# EUROPEAN PATENT APPLICATION

(11) **EP 4 723 850 A1**
(43) Date of publication of application: **08.04.2026**
(21) Application number: 25206043.9
(22) Date of filing: 01.10.2025
(51) Int. Cl.: H10K 59/121, H10K 59/131, H10K 59/65

(54) **ELECTRONIC APPARATUS**

(30) Priority: 02.10.2024 KR 20240134360
(71) Applicant: Samsung Display Co., Ltd., Yongin-si, Gyeonggi-do 17113 (KR)
(72) Inventor: BOK, Seung-Lyong, 17113 Yongin-si (KR)
(74) Representative: Walaski, Jan Filip

(57) **Abstract**

An electronic apparatus including an electronic module, and a display panel including a first area overlapping the electronic module on a plane. The display panel may include a plurality of first pixels configured to provide light to the first area, a plurality of second pixels configured to provide light to a second area, the second area having a lower light transmittance than the first area, and a plurality of third pixels configured to provide light to a third area, the third area being defined between the first area and the second area. The first pixels may include a plurality of first emission parts in the first area, a first group including first pixel drivers which are at one side with respect to the first area and are connected to some of the first emission parts, and a second group including first pixel drivers.

## Description

### BACKGROUND

The present disclosure relates to an electronic apparatus.

An electronic apparatus may be an apparatus including various electronic parts such as display panel and an electronic module. The electronic module may include a camera, an infrared ray sensor, a proximity sensor, and/or the like. The electronic module may be disposed below the display panel. A transmittance of a partial area of the display panel may be higher than a transmittance of other areas of the display panel. The electronic module may receive an external input through the partial area of the display panel, or provide an output through the partial area of the display panel.

### SUMMARY

The present disclosure provides an electronic apparatus.

One or more embodiments of the present disclosure provide an electronic apparatus including an electronic module, and a display panel including a first area overlapping the electronic module on a plane. The display panel may include a plurality of first pixels configured to provide light to the first area, a plurality of second pixels configured to provide light to a second area, the second area having a lower light transmittance than the first area, and a plurality of third pixels configured to provide light to a third area, the third area being defined between the first area and the second area. The first pixels may include a plurality of first emission parts in the first area, a first group including first pixel drivers which are at one side with respect to the first area and are connected to some of the first emission parts, and a second group including first pixel drivers which are at an opposite side to the one side in a first direction with the first area located between the one side and the other side, and are connected to others of the first emission parts. The third area may include a one side sub-area having the first pixel drivers of the first group, and an opposite side sub-area having the first pixel drivers of the second group, and a shape of the one side sub-area and a shape of the opposite side sub-area may be asymmetric about the first area with respect to an axis parallel to a second direction crossing the first direction.

In one or more embodiments, the one side sub-area and the opposite side sub-area may have different shapes.

In one or more embodiments, the one side sub-area may have a shape asymmetric about an axis extending in the second direction, and the opposite side sub-area may have a same shape as the one side sub-area.

In one or more embodiments, the first pixel drivers of the first group may have a different arrangement shape from the first pixel drivers of the second group.

In one or more embodiments, surface areas of the first pixel drivers of the first group and surface areas of the first pixel drivers of the second group may be different from each other.

In one or more embodiments, the number of the first pixel drivers of the first group and the number of the first pixel drivers of the second group may be different.

In one or more embodiments, at least one of the one side sub-area or the opposite side sub-area may further include a dummy area, the dummy area being not connected to the first emission parts.

In one or more embodiments, a shape of the dummy area of the one side sub-area and a shape of the dummy area of the opposite side sub-area may be asymmetric with respect to the first area.

In one or more embodiments, at least one of the first pixel drivers of the first group may be connected to at least one of the first pixel drivers of the second group through a signal line, and the signal line may extend to overlap the first area.

In one or more embodiments, the signal line may have a curved shape along an extension direction.

In one or more embodiments, the signal line may be on a same layer as a connection line connecting the first pixel drivers and the first emission parts, and the signal line may be spaced from the connection line on a plane.

In one or more embodiments, the signal line may be on a different layer from a connection line connecting the first pixel drivers and the first emission parts.

In one or more embodiments, the electronic apparatus according to an embodiment of the present disclosure may further include a sensor layer on the first to third pixels. The sensor layer may include a plurality of conductive patterns, and at least a portion of the conductive patterns may overlap the first area on a plane.

In one or more embodiments, the electronic apparatus according to an embodiment of the present disclosure may further include a light sensing element in the first area.

In one or more embodiments, each of the first to third pixels may include a pixel electrode, a common electrode on the pixel electrode, and an emission layer located between the pixel electrode and the common electrode, and the common electrode of the first pixel and the common electrode of the third pixel may be spaced from each other on a plane.

In one or more embodiments of the present disclosure, an electronic apparatus includes a plurality of first pixels configured to provide light to a first area, a plurality of second pixels configured to provide light to a second area, the second area having a lower light transmittance than the first area, and a plurality of third pixels configured to provide light to a third area, the third area being between the first area and the second area. Each of the first pixels may include a first emission part in the first area, a first pixel driver in the third area, and a connection line connecting the first emission part to the first pixel driver. The third area may include a first side sub-area at one side with respect to the first area, and a second side sub-area spaced from the first area in a first direction, and having a shape asymmetric to the first side sub-area with respect to a virtual axis extending in a second direction crossing the first direction. The first pixel drivers connected to some of the first emission parts may be within the first side sub-area, and the first pixel drivers connected to others of the first emission parts may be located within the second side sub-area.

In one or more embodiments, the number of the first pixel drivers located within the first side sub-area and the number of the first pixel drivers located within the second side sub-area may be different.

In one or more embodiments, an arrangement shape of the first pixel drivers located within the first side sub-area and an arrangement shape of the first pixel drivers located within the second side sub-area may be different.

In one or more embodiments, respective surface areas of the first pixel drivers located within the first side sub-area and respective surface areas of the first pixel drivers located within the second side sub-area may be different from each other.

In one or more embodiments, the third area may further include a third side sub-area and a fourth side sub-area spaced apart from each other in the second direction, and a shape of the third side sub-area and a shape of the fourth side sub-area may be asymmetric or axisymmetric with respect to an axis extending in the first direction.

According to an embodiment, there is provided an electronic apparatus comprising an electronic module; and a display panel including a first area (A1) overlapping the electronic module on a plane, wherein the display panel comprises a plurality of first pixels (PX1) configured to provide light to the first area; a plurality of second pixels (PX2) configured to provide light to a second area (A2), the second area having a lower light transmittance than the first area; and a plurality of third pixels (PX3) configured to provide light to a third area (A3), the third area being between the first area (A1) and the second area (A2), wherein the first pixels comprise: a plurality of first emission parts (EP1a - e) in the first area; a first group of first pixel drivers (CP1d, CP1e) at one side of the first area and connected to some of the first emission parts; and a second group of first pixel drivers (CP1a - CP1c)_at an opposite side of the first area in a first direction and connected to others of the first emission parts, wherein the third area (A3) comprises: a first sub-area (A3L, A3U) having the first pixel drivers (CP1d, CP1e) of the first group; and a second sub-area (A3R, A3B) having the first pixel drivers (CP1a - CP1c) of the second group, wherein the first and second sub-areas are asymmetric about an axis (CX1, CX2) passing through the center (CTP) of the first area in a second direction that is perpendicular to the first direction.

The first and second sub-areas may be symmetric about an axis passing through the center of the first area in the first direction.

The first and second sub-areas may be asymmetric about an axis passing through the center of the first area in the first direction.

### BRIEF DESCRIPTION OF THE FIGURES

The accompanying drawings are included to provide a further understanding of the present disclosure, and are incorporated in and constitute a part of this specification. The drawings illustrate embodiments and, together with the description, serve to explain principles and scope of the present disclosure. In the drawings:
FIGS. 1A and 1B are perspective views of an electronic apparatus;
FIG. 2A is an exploded perspective view of an electronic apparatus;
FIG. 2B is a block diagram of the electronic apparatus EDE;
FIG. 3 is a cross-sectional view of a display device;
FIG. 4 is a plan view of a display panel;
FIG. 5 is an equivalent circuit diagram of a pixel;
FIGS. 6A - 6C are each an enlarged plan view illustrating a partial area of a display panel;
FIG. 7A is a plan view illustrating a portion of a display panel;
FIG. 7B is a schematic view illustrating a portion of a display panel;
FIGS. 8A and 8B are cross-sectional views of a display device;
FIGS. 9A - 9D are each a schematic plan view illustrating a partial area of a display panel;
FIGS. 10A and 10B are each a schematic plan view illustrating a partial area of a display panel;
FIGS. 11A and 11B are each a cross-sectional view illustrating a portion of a display panel;
FIG. 11C is a plan view illustrating a portion of a display panel;
FIGS. 12A and 12B are each a schematic plan view illustrating a partial area of a display panel;
FIG. 13 is a schematic plan view illustrating a partial area of a display panel; and
FIG. 14 is a schematic plan view illustrating a partial area of a display panel.

### DETAILED DESCRIPTION

In this specification, it will be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols refer to like elements throughout. In the drawings, the thickness, ratio, and size of the elements are exaggerated for effectively describing the technical contents.

As used herein, the term "and/or" includes any and all combinations of one or more of the associated listed elements.

It will be understood that, although the terms "first", "second", etc. may be used herein to describe various elements, the elements are not to be limited by these terms. These terms are only used to distinguish one element from another element. For instance, a first element discussed below could be termed a second element without departing from the spirit and scope of the present disclosure. Similarly, a second element could be termed a first element. In this specification, the singular expressions "a", "an" and "the" are intended to include the plural forms as well, unless the context clearly indicates otherwise.

In addition, the terms "below", "under", "on the lower side", "above", "over", "on the upper side", and/or the like may be used to describe the relationships between the elements illustrated in the drawings. These terms are relative concepts and are described on the basis of the directions indicated in the drawings.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Hereinafter, embodiments will be described with reference to the accompanying drawings.

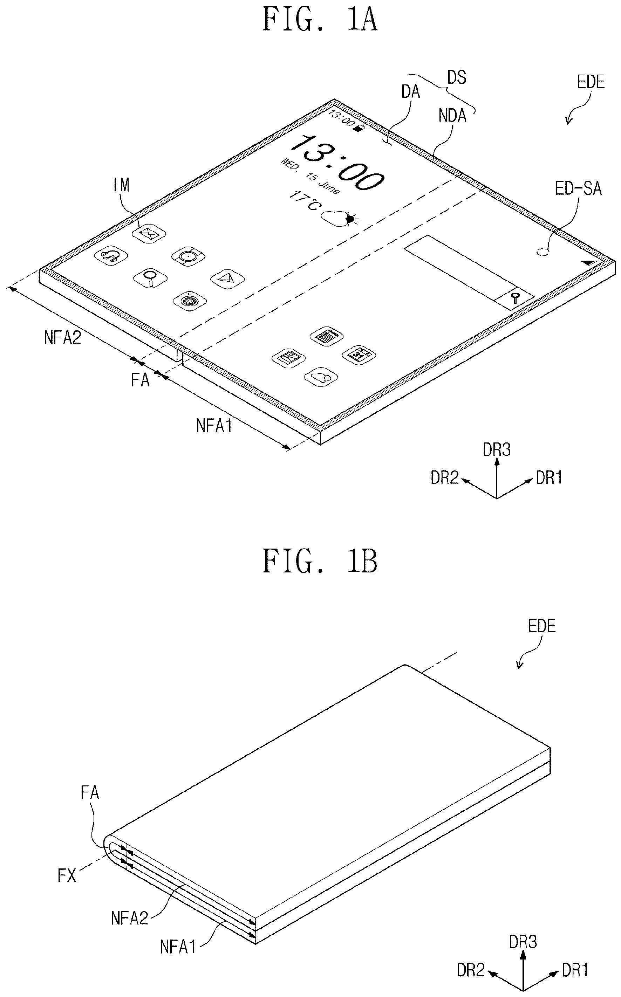

FIGS. 1A and 1B are perspective views of an electronic apparatus EDE. FIG. 1A illustrates a spread state (or an unfolded state) of the electronic apparatus EDE, and FIG. 1B illustrates a folded state of the electronic apparatus EDE.

Referring to FIGS. 1A and 1B, the electronic apparatus EDE may include a display surface DS defined by a first direction DR1 and a second direction DR2 crossing the first direction DR1. The electronic apparatus EDE may provide an image IM for a user through the display surface DS.

The display surface DS may include a display area DA and a non-display area NDA around the display area DA along an edge or a periphery of the display area DA. The display area DA may display the image IM, and the non-display area NDA may not display the image IM. The non-display area NDA may be around (e.g., may surround) the display area DA. However, the present disclosure is not limited thereto, and a shape of the display area DA and a shape of the non-display area NDA may be changed. The non-display area NDA may be omitted.

Hereinafter, a direction substantially perpendicularly crossing a plane defined by the first direction DR1 and the second direction DR2 is defined as a third direction DR3. In addition, the phrase "on a plane" (e.g., in a plan view) used herein may be defined as being in a state when viewed in the third direction DR3.

A sensor area ED-SA may be defined within the display area DA of the electronic apparatus EDE. FIG. 1A illustrates one sensor area ED-SA as an example, but the number of the sensor area ED-SA is not limited thereto. The sensor area ED-SA may be a portion of the display area DA. Thus, the electronic apparatus EDE may display an image through the sensor area ED-SA.

An electronic module may be disposed in an area overlapping the sensor area ED-SA. The electronic module may receive an external input transmitted through the sensor area ED-SA, or provide an output through the sensor area ED-SA. For example, the electronic module may be a camera module, a sensor such as a proximity sensor which measures a distance, a sensor which recognizes part of a user's body (e.g., fingerprint, iris, and/or face), or a small-sized lamp which outputs light, and is not particularly limited thereto. Hereinafter, a camera module will be described as an example of the electronic module overlapping the sensor area ED-SA.

The electronic apparatus EDE may include a folding area FA and a plurality of non-folding areas NFA1 and NFA2. The non-folding areas NFA1 and NFA2 may include a first non-folding area NFA1 and a second non-folding area NFA2. The folding area FA may be disposed between the first non-folding area NFA1 and the second non-folding area NFA2. The folding area FA may be referred to as a foldable area, and the first and second non-folding areas NFA1 and NFA2 may be referred to as first and second non-foldable areas.

As illustrated in FIG. 1B, the folding area FA may be folded about a folding axis FX parallel to the first direction DR1. In a state in which the electronic apparatus EDE is folded, the folding area FA has a certain curvature and a certain radius of curvature. The first non-folding area NFA1 and the second non-folding area NFA2 may face each other, and the electronic apparatus EDE may be inner-folded such that the display surface DS is not exposed to the outside.

The electronic apparatus EDE may be outer-folded such that the display surface DS is exposed to the outside. The electronic apparatus EDE may be inner-folded or outer-folded from an unfolded state, but is not limited thereto. The electronic apparatus EDE may be configured to select any one of an unfolding operation, an inner-folding operation, or an outer-folding operation. A plurality of folding axes may be defined on the electronic apparatus EDE, and the electronic apparatus EDE may be inner-folded or outer-folded from the unfolding state with respect to each of the plurality of folding axes.

Although a foldable electronic apparatus is described as an example of the electronic apparatus EDE with reference to FIGS. 1A and 1B, the present disclosure is not limited to the foldable electronic apparatus EDE. For example, it may be also applied to a rigid electronic apparatus, for example, an electronic apparatus which does not include the folding area FA.

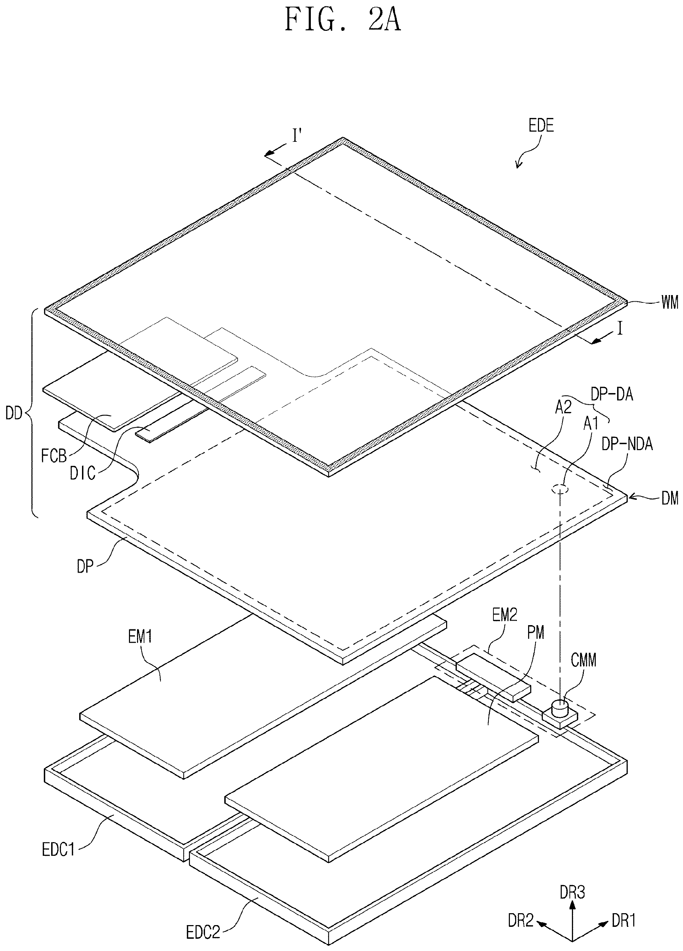

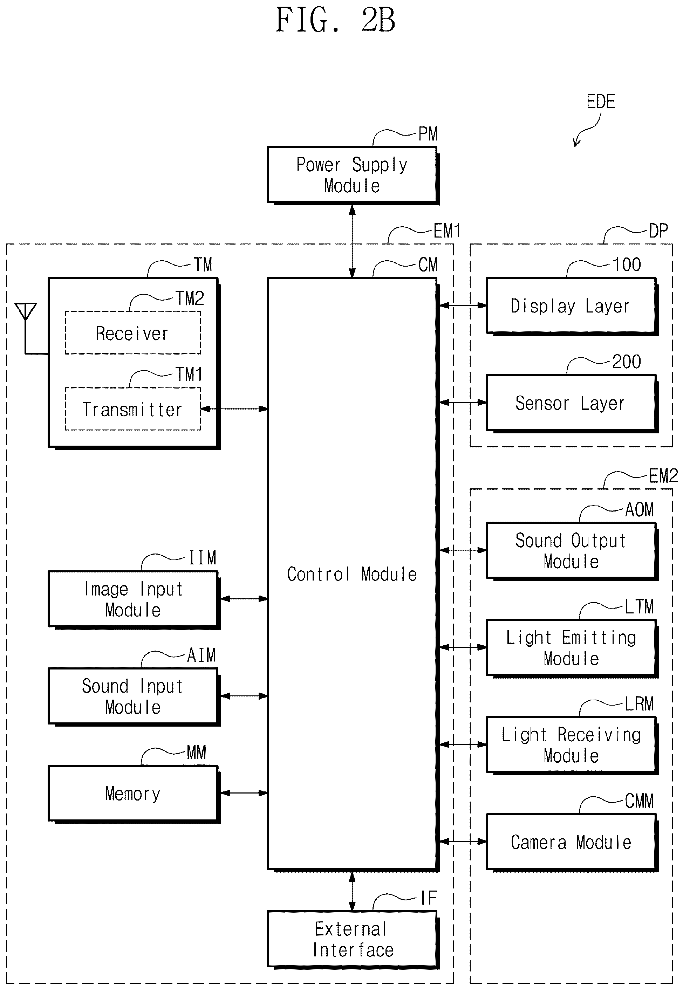

FIG. 2A is an exploded perspective view of an electronic apparatus EDE. FIG. 2B is a block diagram of the electronic apparatus EDE.

Referring to FIGS. 2A and 2B, the electronic apparatus EDE may include a display device DD, a first electronic module EM1, a second electronic module EM2, a power supply module PM, and housings EDC1 and EDC2. The electronic apparatus EDE may further include a mechanical structure for controlling a folding operation of the display device DD.

The display device DD includes a window module WM and a display module DM. The window module WM provides a front surface of the electronic apparatus EDE. The display module DM may at least include a display panel DP. The display module DM generates an image and detects an external input.

In FIG. 2A, the display module DM is illustrated as the same as the display panel DP, but the display module DM may be substantially a stacked structure in which a plurality of components including the display panel DP are stacked. The stacked structure of the display module DM will be described in detail later.

The display panel DP includes a display area DP-DA and a non-display area DP-NDA respectively corresponding to the display area DA (see FIG. 1A) and the non-display area NDA (see FIG. 1A) of the electronic apparatus EDE. In the present disclosure, when "a region/portion corresponds to another region/portion", it means that the region/portions overlap each other, and is not limited to the meaning that the region/portions have the same surface area.

The display area DP-DA may include a first area A1 and a second area A2. The first area A1 may overlap or correspond to the sensor area ED-SA (see FIG. 1A) of the electronic apparatus EDE. Although the first area A1 is illustrated as having a circular shape, the first area A1 may have various shapes such as a polygonal shape, an oval, a figure having at least one curved side, or an irregular shape, and is not limited. The first area A1 may be referred to as a component area, and the second area A2 may be referred to as a main display area or a normal display area.

At least a portion of the first area A1 may have a higher transmittance than the second area A2. Alternatively, a resolution of the first area A1 may be lower than a resolution of the second area A2, but is not limited thereto. For example, at least a portion of the first area A1 may have a higher transmittance than the second area A2, but the resolution of the first area A1 may be substantially the same as the resolution of the second area A2. The first area A1 may overlap a camera module CMM to be described later.

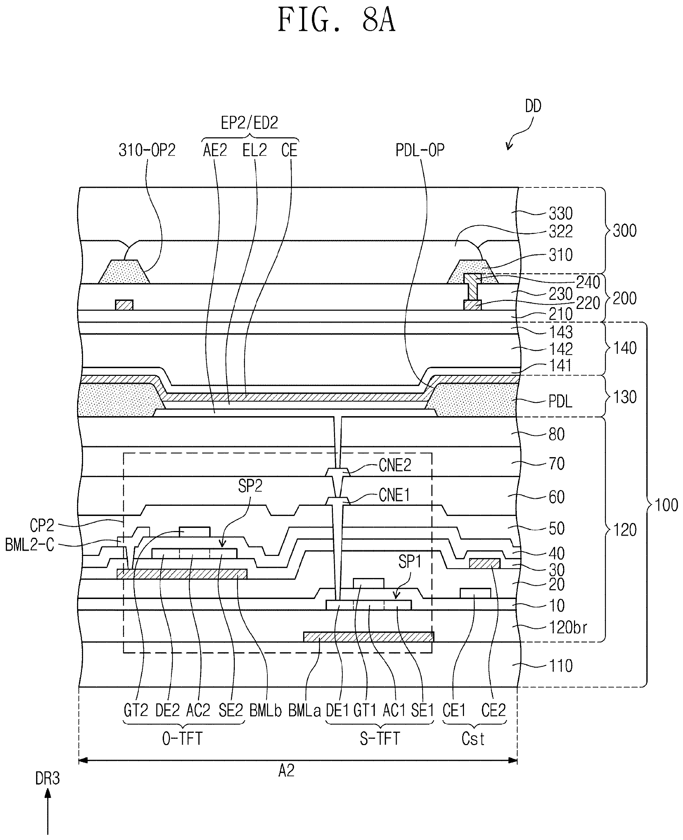

The display panel DP may include a display layer 100 and a sensor layer 200 (e.g., see FIG. 8A).

The display layer 100 may be a component which substantially generates an image. The display layer 100 may be an emissive display layer. For example, the display layer 100 may be an organic light emitting display layer, an inorganic light emitting display layer, an organic-inorganic light emitting display layer, a quantum dot display layer, a micro LED display layer, or a nano LED display layer.

The sensor layer 200 may detect an external input applied from the outside. The external input may be a user's input. The user's input may include various types of external inputs such as part of the user's body, light, heat, pen, and/or pressure.

The display module DM may include a driving chip DIC disposed on the non-display area DP-NDA. The display module DM may further include a flexible circuit film FCB coupled to the non-display area DP-NDA.

The driving chip DIC may include driving elements, for example, a data driving circuit, for driving pixels of the display panel DP. FIG. 2A illustrates a structure in which the driving chip DIC is mounted on the display panel DP, but the present disclosure is not limited thereto. For example, the driving chip DIC may be mounted on the flexible circuit board FCB.

The power supply module PM supplies power required for the overall operation of the electronic apparatus EDE. The power supply module PM may include a general battery module.

The first electronic module EM1 and the second electronic module EM2 include various functional modules for operating the electronic apparatus EDE. Each of the first electronic module EM1 and the second electronic module EM2 may be directly mounted on a motherboard electrically connected to the display panel DP, or may be mounted on a separate board and electrically connected to the motherboard through a connector and/or the like.

The first electronic module EM1 may include a control module CM, a wireless communication module TM, an image input module IIM, a sound input module AIM, a memory MM, and an external interface IF.

The control module CM controls the overall operation of the electronic apparatus EDE. The control module CM may be a microprocessor. For example, the control module CM activates and/or inactivates the display panel DP. The control module CM may control other modules such as the image input module IIM and/or the sound input module AIM, on the basis of a touch signal received from the display panel DP.

The wireless communication module TM may communicate with an external electronic apparatus through a first network (e.g., a short-range communication network such as Bluetooth, WiFi direct, or infrared data association (IrDA)) or a second network (e.g., a long-range communication network such as cellular network, Internet, or computer network (e.g., LAN or WAN)). Communication modules included in the wireless communication module TM may be integrated into one component (e.g., a single chip), or may be implemented as a plurality of components (e.g., chips) separated from each other. The wireless communication module TM may transmit and/receive an audio signal using a general communication channel. The wireless communication module TM may include a transmitter TM1 which modulates and transmits a signal to be transmitted, and a receiver TM2 which demodulates a signal to be received.

The image input module IIM processes an image signal to convert the image signal to image data displayable on the display panel DP. The sound input module AIM receives an external sound signal through a microphone in a recording mode, an audio recognition mode, and/or the like, and converts the external sound signal to electrical audio data.

The external interface IF may include a connector capable of physically connecting the electronic apparatus EDE to an external electronic apparatus. For example, the external interface IF serves as an interface connected to an external charger, a wired/wireless data port, a card (e.g., a memory card, or a SIM or UIM card) socket, and/or the like.

The second electronic module EM2 may include a sound output module AOM, a light emitting module LTM, a light receiving module LRM, the camera module CMM, and/or the like. The sound output module AOM converts sound data received from the wireless communication module TM, or sound data stored in the memory MM, and outputs the converted result to the outside.

The light emitting module LTM generates and outputs light. The light emitting module LTM may output an infrared ray. The light emitting module LTM may include an LED element. The light receiving module LRM may detect an infrared ray. The light receiving module LRM may be activated when an infrared ray having a certain level or more is detected. The light receiving module LRM may include a CMOS sensor. The infrared light generated from the light emitting module LTM may be output and then reflected by an external object (e.g., a user's finger or face), and the reflected infrared light may be incident on the light receiving module LRM.

The camera module CMM may photograph a still image and/or a moving image. The camera module CMM may be provided in plurality. A portion of the plurality of camera modules CMM may overlap the first area A1. An external input (e.g., light) may be provided to the camera module CMM through the first area A1. For example, the camera module CMM may receive natural light through the first area A1 and photograph an external image.

The housings EDC1 and EDC2 accommodate the display module DM, the first and second electronic modules EM1 and EM2, and the power supply module PM. The housings EDC1 and EDC2 protect components, such as the display module DM, the first and second electronic modules EM1 and EM2, and the power supply module PM, which are accommodated in the housings EDC1 and EDC2. As an example, FIG. 2A illustrates the two housings EDC1 and EDC2 separated from each other, but the present disclosure is not limited thereto. The electronic apparatus EDE may further include a hinge structure for connecting the two housings EDC1 and EDC2 to each other. The housings EDC1 and EDC2 may be coupled to the window module WM.

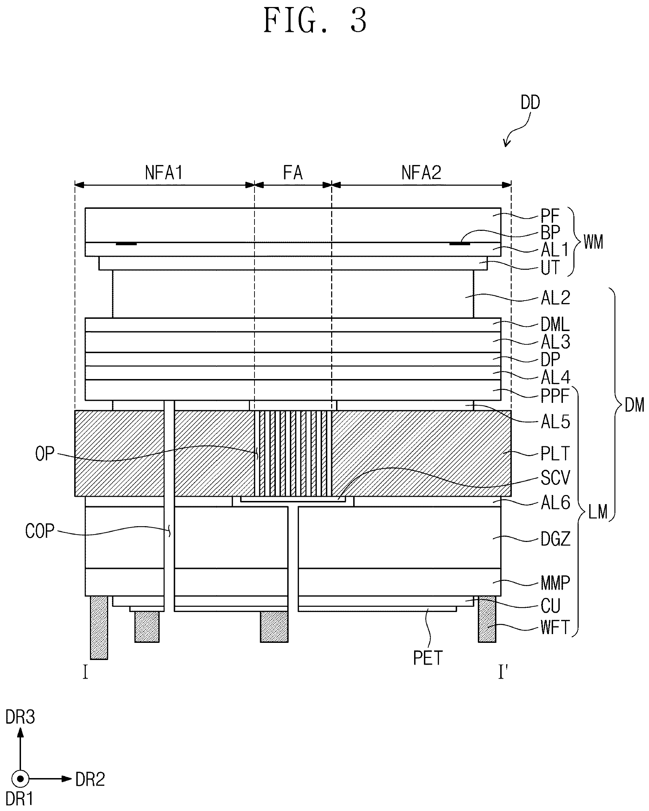

FIG. 3 is a cross-sectional view of a display device DD. FIG. 3 is a cross-sectional view of the display device DD taken along the line I-I' in FIG. 2A.

Referring to FIG. 3, the display device DD includes a window module WM and a display module DM.

The window module WM may include a window UT, a protective film PF disposed on the window UT, and a bezel pattern BP.

The window UT may be chemically strengthened glass. As the window UT is applied to the display device DD, an occurrence of creases may be reduced or minimized even when folding and unfolding are repeated.

The protective film PF may include polyimide, polycarbonate, polyamide, triacetylcellulose, polymethylmethacrylate, and/or polyethylene terephthalate. At least one of a hard coating layer, an anti-fingerprint layer, and/or an anti-reflective layer may be disposed on a top surface of the protective layer PF.

The bezel pattern BP overlaps the non-display area NDA (see FIG. 1A). The bezel pattern BP may be disposed on one surface of the window UT or one surface of the protective film PF. As an example, FIG. 3 illustrates the bezel pattern BP disposed on a bottom surface of the protective film PF. However, the present disclosure is not limited thereto, and the bezel pattern BP may be disposed on the top surface of the protective film PF, a top surface of the window UT, or a bottom surface of the window UT. The bezel pattern BP is a colored light-blocking film and may be formed, for example, through coating. The bezel pattern BP may include a base material and a dye and/or pigment mixed in the base material. The bezel pattern BP may have a closed line shape on a plane.

A first adhesive layer AL1 may be disposed between the protective film PF and the window UT. The first adhesive layer AL1 may be a pressure sensitive adhesive film (PSA) or an optically clear adhesive member (OCA). Adhesive layers to be described below may also be the same as the adhesive layer AL1 and include a general adhesive.

The first adhesive layer AL1 may have a thickness enough to cover the bezel pattern BP. For example, the bezel pattern BP may have a thickness of about 3 micrometers to about 8 micrometers, and the first adhesive layer AL1 may have a thickness to the extent that bubbles are not generated on the periphery of the bezel pattern BP.

The first adhesive layer AL1 may be separated from the window UT. The protective film PF may have lower strength than the window UT and thus may be relatively prone to scratches. The first adhesive layer AL1 and the damaged protective film PF may be separated from the window UT, and then a new protective film PF may be attached to the window UT.

The display module DM may include an impact absorbing layer DML, a display panel DP, and a lower member LM.

The impact absorbing layer DML may be disposed above the display panel DP. The impact absorbing layer DML may be a functional layer for protecting the display panel DP from an external impact. The impact absorbing layer DML may be coupled to the window UT through a second adhesive layer AL2, and coupled to the display panel DP through a third adhesive layer AL3.

The lower member LM may be disposed below the display panel DP. The lower member LM may include a panel protective layer PPF, a support layer PLT, a cover layer SCV, a digitizer DGZ, a shielding layer MMP, a heat dissipation layer CU, a protective layer PET, and a waterproof tape WFT. The lower member LM may not include some of the foregoing components or may further include other components. In addition, the stacking order illustrated in FIG. 3 is just provided as an example, and the stacking order of the components may be changed.

The panel protective layer PPF may be disposed below the display panel DP. The panel protective layer PPF may be attached to a rear surface of the display panel DP through a fourth adhesive layer AL4. The panel protective layer PPF may protect a lower portion of the display panel DP. The panel protective layer PPF may include a flexible plastic material. The panel protective layer PPF may prevent scratches from occurring in the rear surface of the display panel DP during a manufacturing process for the display panel DP. The panel protective layer PPF may be a colored polyimide film. For example, the panel protective layer PPF may be an opaque yellow film, but is not limited thereto.

The support layer PLT is disposed below the panel protective layer PPF. The support layer PLT supports components disposed above the support layer PLT and maintains an unfolded state and a folded state of the display device DD. The support layer PLT may at least include a first support portion corresponding to a first non-folding area NFA1, a second support portion corresponding to a second non-folding area NFA2, and a folding portion corresponding to a folding area FA. The first support portion and the second support portion may be spaced (e.g., spaced apart) from each other in the second direction DR2. The folding portion may be disposed between the first support portion and the second support portion, and a plurality of opening portions OP may be defined in the folding portion. Due to the opening portions OP, flexibility of a portion of the support layer PLT may be improved. Due to the opening portions OP, flexibility of a portion, which overlaps the folding area FA, of the support layer PLT may be improved.

The support layer PLT may include carbon fiber reinforced plastic (CFRP), but is not particularly limited thereto. Alternatively, each of the first support portion and the second support portion may include a non-metal material, plastic, glass fiber-reinforced plastic, and/or glass. The plastic may include polyimide, polyethylene, and/or polyethylene terephthalate, and is not particularly limited. The first support portion and the second support portion may include the same material. The folding portion may include the same material as, or may include a different material from, the first support portion and the second support portion. For example, the folding portion may include a material having an elastic modulus of about 60 Gpa or more, and may include a metal material such as stainless steel. For example, the folding portion may include SUS 304. However, the folding portion is not limited thereto and may include various metal materials.

The support layer PLT may be attached to the panel protective layer PPF through a fifth adhesive layer ALS. The fifth adhesive layer AL5 may be provided in plurality, and the plurality of fifth adhesive layers AL5 may be spaced (e.g., spaced apart) from each other with the folding area FA disposed between the fifth adhesive layers AL5. The fifth adhesive layers AL5 may not overlap the plurality of opening portions OP. In addition, the fifth adhesive layers AL5 may be spaced (e.g., spaced apart) from the plurality of opening portions OP on a plane (e.g., in a plan view). As the fifth adhesive layers AL5 are not disposed in an area corresponding to the folding area FA, flexibility of the support layer PLT may be improved.

In an area overlapping the folding area FA, the panel protective layer PPF may be spaced (e.g., spaced apart) from the support layer PLT. That is, in a portion overlapping the folding area FA, an empty space may be defined between the support layer PLT and the panel protective layer PPF. Because the empty space is defined between the panel protective layer PPF and the support layer PLT, shapes of the plurality of opening portions OP defined in the support layer PLT may be invisible from the outside of the electronic apparatus EDE (see FIG. 1A).

A thickness of the fifth adhesive layer AL5 may be less than a thickness of the fourth adhesive layer AL4. For example, the thickness of the fourth adhesive layer AL4 may be about 25 micrometers, and the thickness of the fifth adhesive layer AL5 may be about 16 micrometers. As the thickness of the fifth adhesive layer AL5 is decreased, a height difference due to the fifth adhesive layer AL5 may be reduced. As the height difference is decreased, deformation of stacked structures due to the folding and unfolding of the electronic apparatus EDE (refer to FIG. 1A) may be reduced, but the plurality of opening portions OP may be visible or the fifth adhesive layer AL5 may be detached due to the repeated folding operations. As the thickness of the fifth adhesive layer AL5 is increased, the plurality of opening portions OP may be invisible and reliability of adhesion of the fifth adhesive layer AL5 may be increased in spite of the repeated folding operations, but the height difference may be increased. Thus, the thickness of the fifth adhesive layer AL5 may be selected within an appropriate range in light of folding reliability, adhesion reliability, and visibility of the plurality of opening portions OP.

The cover layer SCV may be disposed below the support layer PLT. The cover layer SCV may be coupled to the support layer PLT through an adhesive member. The cover layer SCV may cover the plurality of opening portions OP defined in the support layer PLT. Thus, the cover layer SCV may prevent foreign matter from being introduced into the plurality of opening portions OP. The cover layer SCV may have a lower elastic modulus than the support layer PLT. For example, the cover layer SCV may include thermoplastic polyurethane, rubber, and/or silicone, but is not limited thereto.

The digitizer DGZ may be disposed below the support layer PLT. The digitizer DGZ may be provided in plurality. For example, the plurality of digitizers DGZ may be spaced (e.g., spaced apart) from each other in the second direction DR2. A portion of each of the plurality of digitizers DGZ may overlap the non-folding area NFA1 or NFA2, and the remaining portion may overlap the folding area FA. A portion of each of the plurality of digitizers DGZ may overlap a portion of the plurality of opening portions OP on a plane (e.g., in a plan view).

Each of the plurality of digitizers DGZ may include a plurality of loop coils which generate a magnetic field at a preset resonant frequency with an input device (hereinafter referred to as a pen). The plurality of digitizers DGZ may be also referred to as an Electro Magnetic Resonance (EMR) sensing panel.

The magnetic field generated by the plurality of digitizers DGZ is applied to an LC resonance circuit including an inductor (coil) and a capacitor of the pen. The coil generates current by the received magnetic field, and transfers the generated current to the capacitor. Accordingly, the capacitor charges the current input from the coil and discharges the charged current to the coil. As a result, a magnetic field of a resonant frequency is emitted from the coil. The magnetic field emitted by the pen may be re-absorbed by the loop coils of the plurality of digitizers DGZ, and accordingly, it may be determined which position the pen is close to in each of the plurality of digitizers DGZ. However, this is illustrated as an example, and in the electronic apparatus EDE, the digitizers DGZ may be provided by being disposed on a different layer or being inserted into the display panel DP. Alternatively, the digitizers DGZ may be omitted. For example, the digitizers DGZ may be provided as one body together with the sensor layer 200, and thus the sensor layer 200 may also function as a composite sensor capable of detecting both an external touch and a fingerprint. The electronic apparatus EDE may be provided in various shapes, and is not limited.

The digitizers DGZ may be attached to the support layer PLT through a sixth adhesive layer AL6. The sixth adhesive layer AL6 may be provided in plurality, and the plurality of sixth adhesive layers AL6 may be spaced (e.g., spaced apart) from each other with the folding area FA disposed between the sixth adhesive layers AL6. The sixth adhesive layer AL6 may not overlap the plurality of opening portions OP. In addition, the sixth adhesive layer AL6 may be spaced (e.g., spaced apart) from the plurality of opening portions OP on a plane (e.g., in a plan view).

The shielding layer MMP may be disposed below each of the plurality of digitizers DGZ. The shielding layers MMP may each include magnetic metal powder. The shielding layers MMP may each be referred to as a magnetic metal powder layer, a magnetic layer, a magnetic circuit layer, or a magnetic path layer. The shielding layers MMP may shield the magnetic field.

The heat dissipation layer CU may be disposed below each of the shielding layers MMP. The heat dissipation layers CU may be sheets having high thermal conductivity. For example, the heat dissipation layers CU may each include graphite, copper, and/or a copper alloy, but are not particularly limited thereto.

The protective layer PET may be disposed below each of the heat dissipation layers CU. The protective layers PET may be insulating layers. For example, the protective layers PET may be layers provided to prevent introduction of static electricity. Accordingly, the protective layers PET may prevent the flexible circuit film FCB (refer to FIG. 2A) from electrically interfering with members disposed on the protective layers PET.

The waterproof tapes WFT may be attached to the shielding layers MMP and the protective layers PET. The waterproof tape WFT may be attached to a set bracket. Among the waterproof tapes WFT, a thickness of a waterproof tape attached to the shielding layers MMP may be different from a thickness of a waterproof tape attached to the protective layers PET.

A through-hole COP may be defined in at least some components constituting the lower member LM. The through-hole COP may overlap or correspond to the sensor area ED-SA (see FIG. 1A) of the electronic apparatus EDE. At least a portion of the camera module CMM (see FIG. 2A) may be inserted into the through-hole COP.

As an example, FIG. 3 illustrates the through-hole COP provided from a rear surface of one of the protective layers PET up to the fifth adhesive layer AL5, but the present disclosure is not limited thereto. For example, the through-hole COP may be provided from the rear surface of the one protective layer up to a top surface of the panel protective layer PPF or from the rear surface of the one protective layer PET up to a top surface of the fourth adhesive layer AL4.

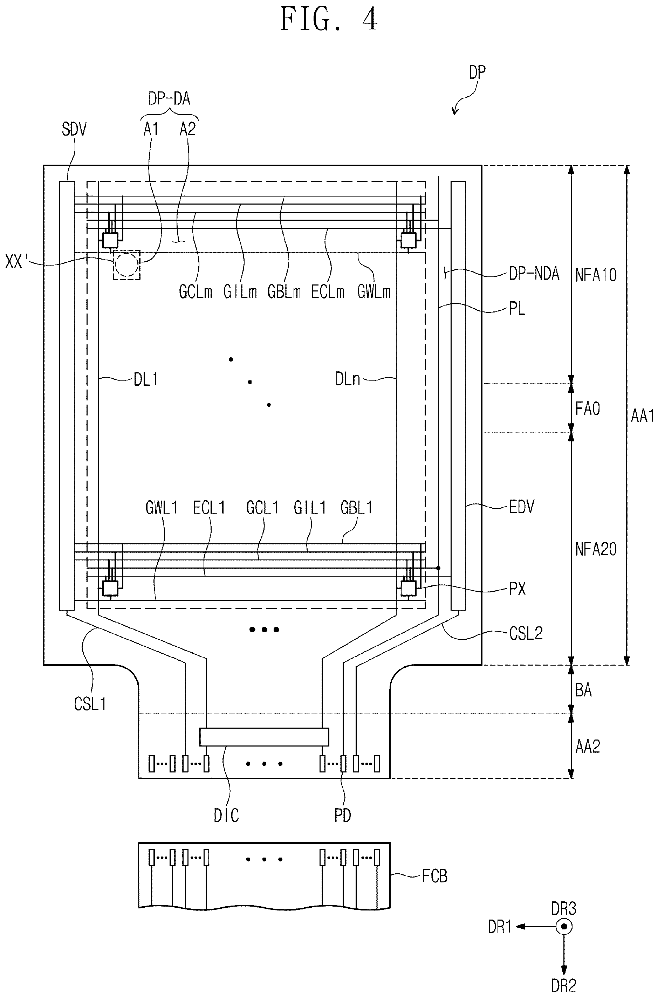

FIG. 4 is a plan view of a display panel DP.

Referring to FIG. 4, a display area DP-DA, and a non-display area DP-NDA around the display area DP-DA may be defined in the display panel DP. The display area DP-DA and the non-display area DP-NDA may be divided according to whether pixels PX are disposed or not. The pixels PX are disposed in the display area DP-DA. A scan driver SDV, a data driver, and an emission driver EDV may be disposed in the non-display region DP-NDA. The data driver may be a partial circuit included in a driving chip DIC.

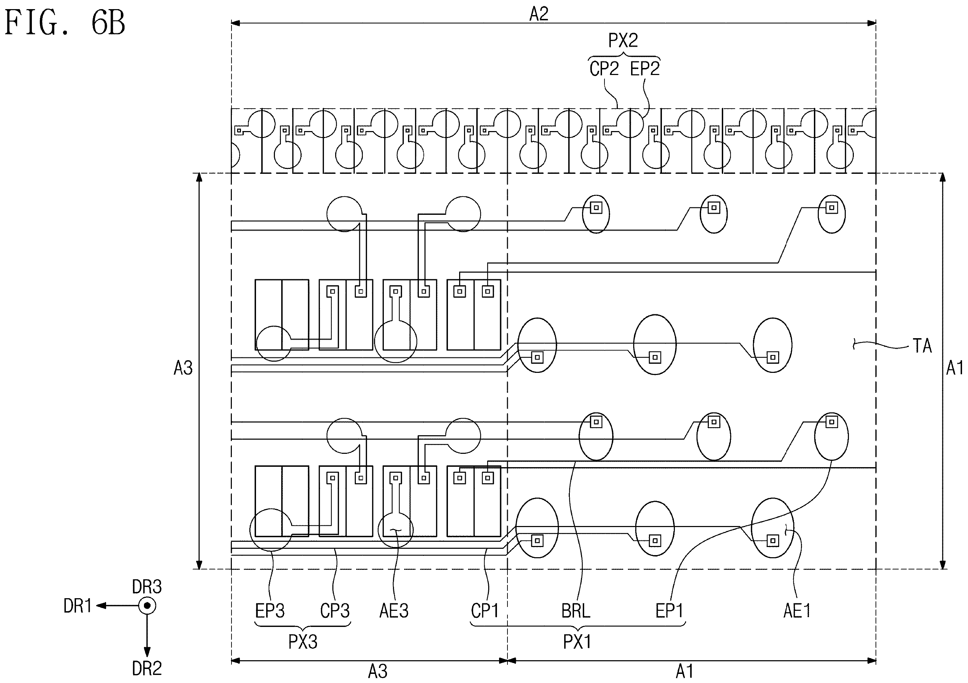

The display area DP-DA may include a first area A1 and a second area A2. The first area A1 and the second area A2 may be divided according to an arrangement interval of the pixels PX, sizes of the pixels PX, shapes of the pixels PX, or the presence or absence of a transmission area TA (see FIG. 6B). The first area A1 and the second area A2 will be described in detail later.

The display panel DP may include a first panel area AA1, a bending area BA, and a second panel area AA2 which are defined along the second direction DR2. The second panel area AA2 and the bending area BA may each be a partial area of the non-display area DP-NDA. The bending area BA is disposed between the first panel area AA1 and the second panel area AA2.

The first panel area AA1 is an area corresponding to the display surface DS in FIG. 1A. The first panel area AA1 may include a first non-folding area NFA10, a second non-folding area NFA20, and a folding area FA0. The first non-folding area NFA10, the second non-folding area NFA20, and the folding area FA0 respectively correspond to the first non-folding area NFA1, the second non-folding area NFA2, and the folding area FA in FIGS. 1A and 1B.

A width (or length) of each of the bending area BA and the second panel area AA2, which is parallel to the first direction DR1, may be less than a width (or length) of the first panel area AA1, which is parallel to the first direction DR1. An area having a smaller length in a bending-axis direction may be more easily bent.

The display panel DP may include the pixels PX, initialization scan lines GIL1 to GILm, compensation scan lines GCL1 to GCLm, write scan lines GWL1 to GWLm, black scan lines GBL1 to GBLm, emission control lines ECL1 to ECLm, data lines DL1 to DLn, first and second control lines CSL1 and CSL2, a driving voltage line PL, and a plurality of pads PD. Here, m and n are each a natural number of 2 or more.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn, respectively.

The initialization scan lines GIL1 to GILm, the compensation scan lines GCL1 to GCLm, the write scan lines GWL1 to GWLm, and the black scan lines GBL1 to GBLm may extend in the first direction DR1 to be electrically connected to the scan driver SDV. The data lines DL1 to DLn may extend in the second direction DR2 and be electrically connected to the driving chip DIC via the bending area BA. The emission control lines ECL1 to ECLm may extend in the first direction DR1 to be electrically connected to the emission driver EDV.

The driving voltage line PL may include a portion extending in the first direction DR1 and a portion extending in the second direction DR2. The portion extending in the first direction DR1 and the portion extending in the second direction DR2 may be disposed on different layers. The portion, which extends in the second direction DR2, of the driving voltage line PL may extend to the second panel area AA2 via the bending area BA. The driving voltage line PL may provide a driving voltage to each of the pixels PX.

The first control line CSL1 may be connected to the scan driver SDV and extend toward a lower end of the second panel area AA2 via the bending area BA. The second control line CSL2 may be connected to the emission driver EDV and extend toward the lower end of the second panel area AA2 via the bending area BA.

The pads PD may be arranged adjacent to the lower end of the second panel area AA2 when viewed on a plane (e.g., in a plan view). The driving chip DIC, the driving voltage line PL, the first control line CSL1, and the second control line CSL2 may be electrically connected to the pads PD. A flexible circuit film FCB may be electrically connected to the pads PD through an anisotropic conductive adhesive layer.

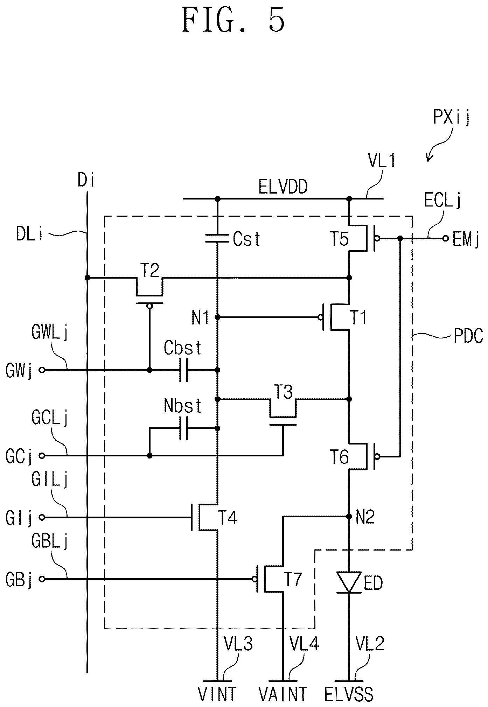

FIG. 5 is an equivalent circuit diagram of a pixel PXij.

As an example, FIG. 5 illustrates an equivalent circuit diagram of one pixel PXij from among the plurality of pixels PX (see FIG. 4). Because the plurality of pixels PX have the same circuit structure, the circuit structure of the pixel PXij will be described, and the remaining pixels PX will not be specifically described.

Referring to FIGS. 4 and 5, the pixel PXij is connected to an i-th data line DLi of data lines DL1 to DLn, a j-th initialization scan line GILj of initialization scan lines GIL1 to GILm, a j-th compensation scan line GCLj of compensation scan lines GCL1 to GCLm, a j-th write scan line GWLj of write scan lines GWL1 to GWLm, a j-th black scan line GBLj of black scan lines GBL1 to GBLm, a j-th emission control line ECLj of emission control lines ECL1 to ECLm, first and second driving voltage lines VL1 and VL2, and first and second initialization voltage lines VL3 and VL4. Here, i is an integer of 1 to n, and j is an integer of 1 to m.

The pixel PXij includes a light emitting element ED and a pixel circuit PDC. The light emitting element ED may be a light emitting diode. As an example, the light emitting element ED may be an organic light emitting diode (OLED) including an organic emission layer, but is not particularly limited thereto. The pixel circuit PDC may control an amount of current flowing through the light emitting element ED in response to a data signal Di. The light emitting element ED may emit light with a certain luminance corresponding to the amount of current provided from the pixel circuit PDC.

The pixel circuit PDC may include first to seventh transistors T1, T2, T3, T4, T5, T6, and T7, and first to third capacitors Cst, Cbst, and Nbst. The configuration of the pixel circuit PDC is not limited to that illustrated in FIG. 5. The pixel circuit PDC illustrated in FIG. 5 is just provided as one example, and the configuration of the pixel circuit PDC may be modified and implemented.

At least one of the first to seventh transistors T1, T2, T3, T4, T5, T6, and T7 may be a transistor including a low-temperature polycrystalline silicon (LTPS) semiconductor layer. At least one of the first to seventh transistors T1, T2, T3, T4, T5, T6, and T7 may be a transistor including an oxide semiconductor layer. For example, the third and fourth transistors T3 and T4 may be oxide semiconductor transistors, and the first, second, fifth, sixth, and seventh transistors T1, T2, T5, T6, and T7 may be LTPS transistors.

Specifically, the first transistor T1 which directly affects brightness of the light emitting element ED may include a semiconductor layer including polycrystalline silicon having high reliability, thereby achieving a display device having a high resolution. As an oxide semiconductor has high carrier mobility and low leakage current, voltage drop is not great even when a driving period of time is long. That is, as a color change of an image due to the voltage drop is not great even during low-frequency driving, low-frequency driving is possible. As above, the oxide semiconductor has the merit of low leakage current, and thus at least one of the third transistor T3 or the fourth transistor T4, each of which is connected to a gate electrode of the first transistor T1, may be employed as the oxide semiconductor, thereby preventing leakage current likely to flow to the gate electrode of the first transistor T1 and also reducing power consumption.

Some of the first to seventh transistors T1, T2, T3, T4, T5, T6, and T7 may be p-type transistors, and the remainder may be n-type transistors. For example, the first, second, fifth, sixth, and seventh transistors T1, T2, T5, T6, and T7 may be p-type transistors, and the third and fourth transistors T3 and T4 may be n-type transistors.

The configuration of the pixel circuit PDC is not limited to that illustrated in FIG. 5. The pixel circuit PDC illustrated in FIG. 5 is just one example, and the configuration of the pixel circuit PDC may be modified and implemented. For example, all the first to seventh transistors T1, T2, T3, T4, T5, T6, and T7 may be either p-type transistors or n-type transistors. Alternatively, the first, second, fifth, and sixth transistors T1, T2, T5, and T6 may be n-type transistors, and the third. fourth, and seventh transistors T3, T4, and T7 may be n-type transistors.

The j-th initialization scan line GILj, the j-th compensation scan line GCLj, the j-th write scan line GWLj, the j-th black scan line GBLj, and the j-th emission control line ECLj may transmit, to the pixel PXij, a j-th initialization scan signal GIj, a j-th compensation scan signal GCj, a j-th write scan line signal GWj, a j-th black scan signal GBj, and a j-th emission control signal EMj, respectively. The i-th data line DLi transmits an i-th data signal Di to the pixel PXij. The i-th data signal Di may have a voltage level corresponding to an image signal input to the display device DD (see FIG. 3).

The first and second driving voltage lines VL1 and VL2 may respectively transmit a first driving voltage ELVDD and a second driving voltage ELVSS to the pixel PXij. In addition, the first and second initialization voltage lines VL3 and VL4 may respectively transmit a first initialization voltage VINT and a second initialization voltage VAINT to the pixel PXij.

The first transistor T1 is connected between the light emitting element ED and the first driving voltage line VL1 which receives the first driving voltage ELVDD. The first transistor T1 includes a first electrode connected to the first driving voltage line VL1 via the fifth transistor T5, a second electrode connected to a pixel electrode (or referred to as an anode) of the light emitting element ED via the sixth transistor T6, and a third electrode (e.g., a gate electrode) connected to one end (e.g., a first node N1) of the first capacitor Cst. The first transistor T1 may receive the i-th data signal Di transmitted by the i-th data line DLi according to a switching operation of the second transistor T2, and then supply driving current to the light emitting element ED.

The second transistor T2 is connected between the i-th data line DLi and the first electrode of the first transistor T1. The second transistor T2 includes a first electrode connected to the i-th data line DLi, a second electrode connected to the first electrode of the first transistor T1, and a third electrode (e.g., a gate electrode) connected to the j-th write scan line GWLj. The second transistor T2 may be turned on in response to the j-th write scan line signal GWj received through the j-th write scan line GWLj, and transmit the i-th data signal Di received from the i-th data line DLi to the first electrode of the first transistor T1. The second capacitor Cbst may have one end connected to the third electrode (e.g., gate electrode) of the second transistor T2, and the other end connected to the first node N1.

The third transistor T3 is connected between the first node N1 and the second electrode of the first transistor T1. The third transistor T3 includes a first electrode connected to the third electrode (e.g., the gate electrode) of the first transistor T1, a second electrode connected to the second electrode of the first transistor T1, and a third electrode (e.g., a gate electrode) connected to the j-th compensation scan line GCLj. The third transistor T3 may be turned on in response to the j-th compensation scan signal GCj received through the j-th compensation scan line GCLj, and connect the third electrode (e.g., the gate electrode) of the first transistor T1 and the second electrode of the first transistor T1 to each other so that the first transistor T1 is diode-connected. The third capacitor Nbst may have one end connected to the third electrode (e.g., the gate electrode) of the third transistor T3, and the other end connected to the first node N1.

The fourth transistor T4 is connected between the first node N1 and the first initialization voltage line VL3 to which the first initialization voltage VINT is applied. The fourth transistor T4 includes a first electrode connected to the first initialization voltage line VL3 to which the first initialization voltage VINT is transmitted, a second electrode connected to the first node N1, and a third electrode (e.g., a gate electrode) connected to the j-th initialization scan line GILj. The fourth transistor T4 is turned on in response to the j-th initialization scan signal GIj received through the j-th initialization scan line GILj. The turned-on fourth transistor T4 transmits the first initialization voltage VINT to the first node N1 to initialize a potential of the third electrode or the gate electrode (i.e., a potential of the first node N1) of the first transistor T1.

The fifth transistor T5 includes a first electrode connected to the first driving voltage line VL1, a second electrode connected to the first electrode of the first transistor T1, and a third electrode (e.g., a gate electrode) connected to the j-th emission control line ECLj. The sixth transistor T6 includes a first electrode connected to the second electrode of the first transistor T1, a second electrode connected to the pixel electrode of the light emitting element ED, and a third electrode (e.g., a gate electrode) connected to the j-th emission control line ECLj.

The fifth and sixth transistors T5 and T6 are turned on at the same time in response to the j-th emission control signal EMj received through the j-th emission control line ECLj. The first driving voltage ELVDD applied through the turned-on fifth transistor T5 may be compensated through the diode-connected first transistor T1, and then transmitted to the light emitting element ED through the sixth transistor T6.

The seventh transistor T7 includes a first electrode connected to the second initialization voltage line VL4, to which the second initialization voltage VAINT is transmitted, a second electrode connected to the second electrode of the sixth transistor T6, and a third electrode (e.g., a gate electrode) connected to the black scan line GBLj. The second initialization voltage VAINT may have a voltage level that is less than or equal to that of the first initialization voltage VINT.

The first capacitor Cst may have one end connected to the third electrode or the gate electrode (i.e., the first node N1) of the first transistor T1, and the other end connected to the first driving voltage line VL1. A cathode of the light emitting element ED may be connected to the second driving voltage line VL2 which transmits the second driving voltage ELVSS. The second driving voltage ELVSS may have a lower voltage level than the first driving voltage ELVDD.

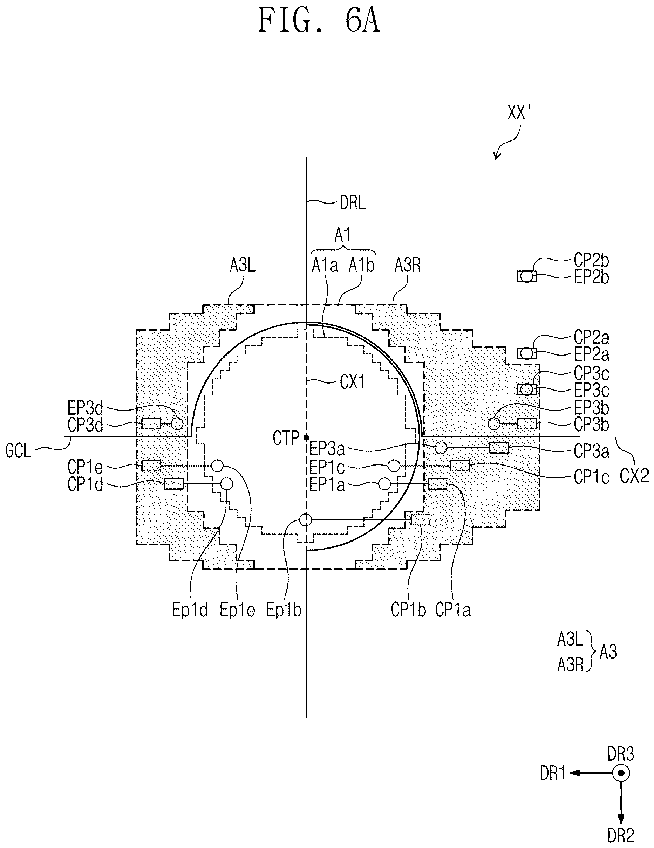

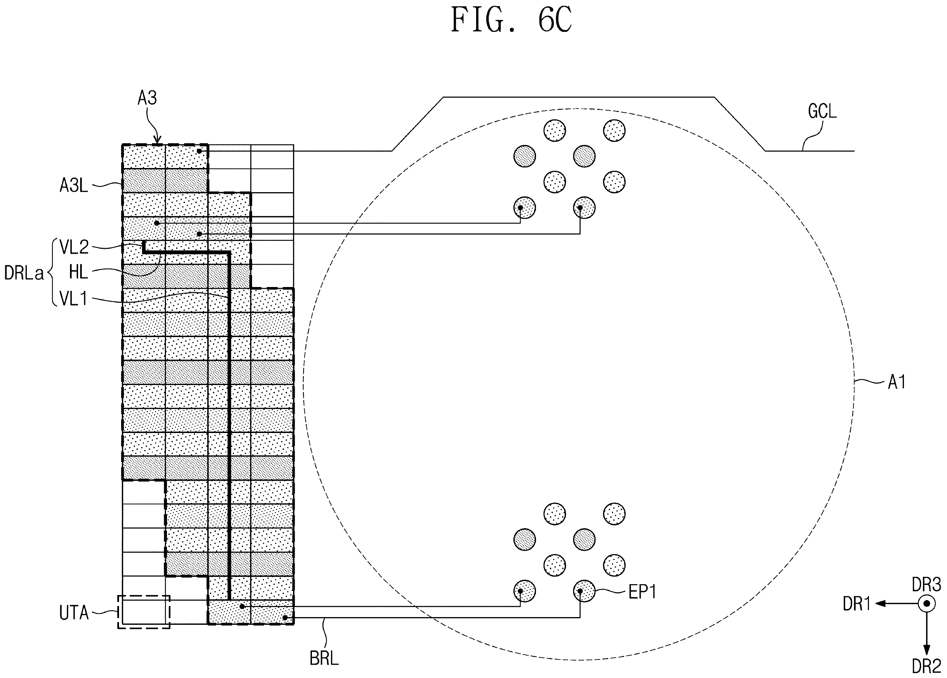

FIGS. 6A - 6C are each an enlarged plan view illustrating a partial area of a display panel. FIG. 6A illustrates an enlarged view of area XX' illustrated in FIG. 4, and FIG. 6B illustrates an enlarged view of a partial area in FIG. 6A. FIG. 6C schematically illustrates a portion in FIG. 6A. Hereinafter, an example will be described with reference to FIGS. 6A to 6C. The same/similar components as/to those described with reference to FIGS. 1 - 5 are designated by the same/similar reference numbers or symbols, and the redundant contents are omitted.

Referring to FIGS. 6A and 6B, a display panel DP may further include a third area A3. The third area A3 may be defined between a first area A1 and a second area A2. The third area A3 may be referred to as an auxiliary display area, or may be referred to as an intermediate area or a transition area. Accordingly, pixels PX includes a first pixel PX1, a second pixel PX2, and a third pixel PX3. The first to third pixels PX1, PX2 and PX3 may emit light in the first to third areas A1, A2 and A3, respectively. Each of the first pixel PX1, the second pixel PX2, and the third pixel PX3 may be provided in plurality. In this case, the first to third pixels PX1, PX2 and PX3 may include a red pixel, a green pixel, and a blue pixel, and may further include a white pixel. For easy explanation, FIG. 6A illustrates, as an example of the first pixel PX1, five first emission parts EP1a, EP1b, EP1c, EP1d, and EP1e and first pixel drivers CP1a, CP1b, CP1c, CP1d, and CP1e which are connected to the first emission parts EP1a, EP1b, EP1c, EP1d, and EP1e, respectively, and illustrates, as an example of the second pixel PX2, two second emission parts EP2a and EP2b and second pixel drivers CP2a and CP2b which are connected to the second emission parts EP2a and EP2b, respectively. In addition, five third emission parts EP3a, EP3b, EP3c, EP3d, and EP3e and third pixel drivers CP3a, CP3b, CP3c, CP3d, and CP3e which are connected to the third emission parts EP3a, EP3b, EP3c, EP3d, and EP3e, respectively, are illustrated as an example of the third pixel PX3.

The first pixel PX1 may include a first emission part EP1 and a first pixel driver CP1 which is connected to the first emission part EP1 and drives the first emission part EP1. The first emission part EP1 may be disposed in the first area A1, and the first pixel driver CP1 may be disposed in an area different from the first area A1. In this example, the first pixel driver CP1 may be disposed in the third area A3. As the first pixel driver CP1 is not disposed in the first area A1, a light transmittance of the first area A1 may be increased.

In addition, a transmission part TA and the first emission part EP1 may be disposed in the first area A1. The transmission part TA may correspond to an area, in which the first emission part EP1 is not disposed, of the first area A1. An area other than an area, in which the first emission part EP1 is disposed, may be designed to function as the transmission part TA so that the light transmittance of the first area A1 may become higher than that of the second area A2 or third area A3 which does not include the transmission part TA.

The first emission part EP1 and the first pixel driver CP1 may be connected to each other through a connection line BRL1. The connection line BRL1 may extend from the first area A1 and may be connected to the first pixel driver CP1 disposed in the third area A3. The connection line BRL1 may overlap the transmission part TA or extend around the transmission part TA.

The connection line BRL1 may include a transparent conductive material or a light transmissive material. For example, the connection line BRL1 may include a transparent conductive oxide (TCO) film including an indium tin oxide (ITO), an indium zinc oxide (IZO), an indium gallium zinc oxide (IGZO), a zinc oxide (ZnO), an indium oxide (In₂O₃), and/or the like. As the connection line BRL1 includes a material having a high light transmittance, the light transmittance of the first area A1 may be increased. However, this is illustrative, and as long as the light transmittance of the first area A1 satisfies a certain range, a light transmittance required for a camera module CMM is sufficient, or the connection line BRL1 extends around the transmission part TA, the connection line BRL1 may include a non-transparent material and is not limited.

In this example, the first area A1 may include a center area A1a and a side area A1b. The side area A1b may be provided in an annular shape around (e.g., surrounding) an edge of the center area A1a. The center area A1a may be an area in the first area A1 through which light provided to the camera module CMM (see FIG. 2A) passes. The first emission parts EP1a, EP1b, EP1c, EP1d, and EP1e may be mainly disposed in the center area A1a.

The side area A1b may be an area in which lines GCL and DRL bypass the center area A1a without crossing the center area A1a. The line GCL having a portion extending in the first direction DR1 may be a portion of each of the initialization scan lines GIL1 to GILm, the compensation scan lines GCL1 to GCLm, the write scan lines GWL1 to GWLm, the black scan lines GBL1 to GBLm, and the emission control lines ECL1 to ECLm, which are described with reference to FIG. 4. The line DRL having a portion extending in the second direction DR2 may be a portion of the data lines DL1 to DLn described with reference to FIG. 4. FIG. 6A illustrates one of each of the lines GCL and DRL, but each of the lines GCL and DRL may be provided in plurality.

As the lines GCL and DRL do not cross the center area A1a but bypass the center area A1a via the side area A1b, the transmittance of the center area A1a may be more improved. Alternatively, as illustrated in FIG. 6C, the lines GCL and DRL may extend while bypassing the entire first area A1. Therefore, the quality of an image obtained in the camera module CMM may be improved. However, this is illustrated as an example. A portion of the first emission parts EP1a, EP1b, EP1c, EP1d, and EP1e may be also disposed in the side area A1b, or a portion of the lines GCL and DRL may be also disposed in the center area A1a, however, the present disclosure is not limited.

The second pixel PX2 may include a second emission part EP2 and a second pixel driver CP2 which is connected to the second emission part EP2 and drives the second emission part EP2. The third pixel PX3 may include a third emission part EP3 and a third pixel driver CP3 which is connected to the third emission part EP3 and drives the third emission part EP3. Each of the first to third emission parts EP1, EP2, and EP3 may correspond to an area on which light generated by the light emitting element ED described above is displayed. Each of the first to third pixel drivers CP1, CP2, and CP3 may correspond to an area in which the pixel circuit PDC described above is disposed.

Referring to FIGS. 6A and 6B, the second area A2 may be defined as an area having a lower transmittance than the first area A1. The second emission part EP2 and the second pixel driver CP2 may be disposed in the second area A2. For easy explanation, FIG. 6A illustrates two second emission parts EP2a and EP2b and two second pixel drivers CP2a and CP2b as an example. The second emission part EP2 may overlap the second pixel driver CP2. That is, an area in which the emission part EP2 is disposed, and an area in which the pixel driver CP2 is disposed, may not be separated but overlap each other in the second area A2.

The number of first emission parts EP1, which is disposed in the first area A1, within a unit area or the same area may be less than the number of second emission parts EP2, which is disposed in the second area A2, within the unit area or the same area. For example, a resolution of the first area A1 may be about 1/2, 3/8, 1/3, 1/4, 2/9, 1/8, 1/9, 1/16, or the like a resolution of the second area A2. Specifically, the resolution of the second area A2 may be about 400 ppi or more, and the resolution of the first area A1 may be about 200 ppi or about 100 ppi. However, this is just one example, and the present disclosure is not particularly limited thereto.

The first emission part EP1 may have an oval shape in which a width in the second direction DR2 is greater than a width in the first direction DR1. In order to secure a distance from the second emission part EP2 disposed in the second area A2, some of the first emission parts EP1 arranged most adjacent to the second area A2 may have oval shapes, and each of the second and third emission parts EP2 and EP3 may have a circle shape. However, this is illustrated as an example, and the first emission part EP1 may also have a circular shape, and each of the second and third emission parts EP2 and EP3 may also have an oval shape, and are not limited.

The third area A3 may be adjacent to the first area A1. The third area A3 may be disposed between the first area A1 and the second area A2. The third area A3 may be around (e.g., may surround) at least a portion of the first area A1. In this example, the third area A3 may be spaced (e.g., spaced apart) from a peripheral area DP-NA (e.g., the non-display area DP-NDA) with the second area A2 disposed between the third area A3 and the peripheral area DP-NA. However, the present disclosure is not limited thereto, and the third area A3 may be in contact with the peripheral area DP-NA.

The third area A3 may be an area having a lower transmittance than the first area A1. The first pixel driver CP1 of the first pixel PX1, and the third emission part EP3 and the third pixel driver CP3 of the third pixel PX3 may be disposed in the third area A3. Thus, a light transmittance of the third area A3 may be less than the light transmittance of the first area A1.

Referring to FIG. 6A again, the third area A3 may include a plurality of sub-areas disposed on opposite sides on the basis of the first area A1. The third area A3 in this example may include a left sub-area A3L and a right sub-area A3R. The left may be a position in the same direction as the first direction DR1 from a center of the first area A1, and the right may be a position in an opposite direction to the first direction DR1 from the center of the first area A1. The left sub-area A3L may be disposed on the left on the basis of the first area A1, and the right sub-area A3R may be disposed on the right on the basis of the first area A1.

The left sub-area A3L and the right sub-area A3R may be spaced (e.g., spaced apart) from each other with the first area A1 disposed between the left sub-area A3L and the right sub-area A3R. The left sub-area A3L and the right sub-area A3R may have an asymmetric shape with respect to a virtual first center axis CX1 passing through the center CTP of the first area A1 and extending to be parallel to the second direction DR2 (or extending in the second direction). In the present disclosure, asymmetry may be a shape which is not linearly symmetric (non-axisymmetric). In this example, the first center axis CX1 may be a line matching a data line DRL illustrated herein. Specifically, the left sub-area A3L and the right sub-area A3R may have different surface areas. The left sub-area A3L and the right sub-area A3R may have different shapes.

The third area A3 will be described in more detail with reference to FIG. 6C. As an example, FIG. 6C illustrates only a left area of the third area A3. When the third area A3 is partitioned into a matrix shape in which a plurality of unit areas UTA are arranged along the first direction DR1 and the second direction DR2, pixel drivers may be disposed in only some of the unit areas UTA which are matrix-arranged. Each of the unit areas UTA may correspond to one pixel driver, and each of the pixel drivers may be the first pixel driver CP1. For easy explanation, in FIG. 6C, areas, in which the first pixel drivers CP1 are disposed, of the unit areas UTA are shaded, and the areas are differently shaded so as to correspond to the emission parts EP1 to be connected.

The first pixel drivers CP1 disposed in the third area A3 may include a first group disposed in the left sub-area A3L, and a second group disposed in the right sub-area A3R. The first pixel drivers CP1 of the first group are connected to some of the first emission parts EP1 disposed in the first area A1. The first pixel drivers CP1 of the second group are connected to other ones of the first emission parts EP1 disposed in the first area A1. In a case in which the third area A3 includes only the left sub-area A3L and the right sub-area A3R, the first pixel drivers CP1 of the second group may be connected to the remainder of the first emission parts EP1 disposed in the first area A1.

The left sub-area A3L may be an area of the third area A3, in which the first pixel drivers CP1 disposed on the left with respect to the first center axis CX1 and connected to the first emission parts EP1, respectively, are disposed. That is, the left sub-area A3L may be an area of the third area A3, which is occupied by the first pixel drivers CP1 of the first group. Likewise, the right sub-area A3R may be an area of the third area A3, in which the first pixel drivers CP1 disposed on the right with respect to the first center axis CX1 and connected to the first emission parts EP1, respectively, are disposed. That is, the right sub-area A3R may be an area of the third area A3, which is occupied by the first pixel drivers CP1 of the second group.

The left sub-area A3L may have an irregular shape. An arrangement of the first pixel drivers CP1 disposed in the left sub-area A3L may be top-bottom asymmetric. As illustrated in FIG. 6C, the first pixel drivers CP1 corresponding to the first emission parts EP1 arranged on the same column in the first area A1 may not be arranged on the same column in the third area A3. Two first pixel drivers CP1 respectively connected to the emission parts constituting the same column may be connected to the same data line DRLa, and thus the data line DRLa may include at least one horizontal portion HL in addition to vertical portions VL1 and VL2 extending in the second direction DR2. However, the horizontal portion HL may be sufficient as long as extending in a direction crossing the vertical portions VL1 and VL2, and may not mean one orthogonal or perpendicular to the vertical portions VL1 and VL2.

The horizontal portion HL may be provided as one body on the same layer as the vertical portions VL1 and VL2, or may be disposed on a different layer from the vertical portions VL1 and VL2 so as to avoid interference with other adjacent signal line and connected to the vertical portions VL1 and VL2 through a contact hole and/or the like. As the data line DRLa further includes the horizontal portion HL, an arrangement of the pixel drivers CP1 disposed in the third area A3 may be designed independently of the first emission parts EP1, and even when the arrangement of the pixel drivers CP1 is variously changed, the first emission parts EP1 constituting the same column may be driven using one data line DRLa. However, this is illustrated as an example, and when the left sub-area A3L and the right sub-area A3R have an asymmetric shape, the left sub-area A3L itself may have a top-bottom symmetric shape and is not limited.

When the left sub-area A3L and the right sub-area A3R have an asymmetric shape with respect to the first center axis CX1, it may mean that the arrangement of the first pixel drivers CP1 disposed in the left sub-area A3L and the arrangement of the first pixel drivers CP1 disposed in the right sub-area A3R have different shapes. When the left sub-area A3L and the right sub-area A3R have an asymmetric shape, it may mean that the number of the first pixel drivers CP1 disposed in the left sub-area A3L and the number of the first pixel drivers CP1 disposed in the right sub-area A3R are different.

As the left sub-area A3L and the right sub-area A3R have an asymmetric shape, constraints on the arrangement of the first emission parts EP1 disposed in the first area A1 or the design of the first pixel drivers CP1 may be reduced. Accordingly, design degrees of freedom in pixel arrangement in the first area A1 may be improved.

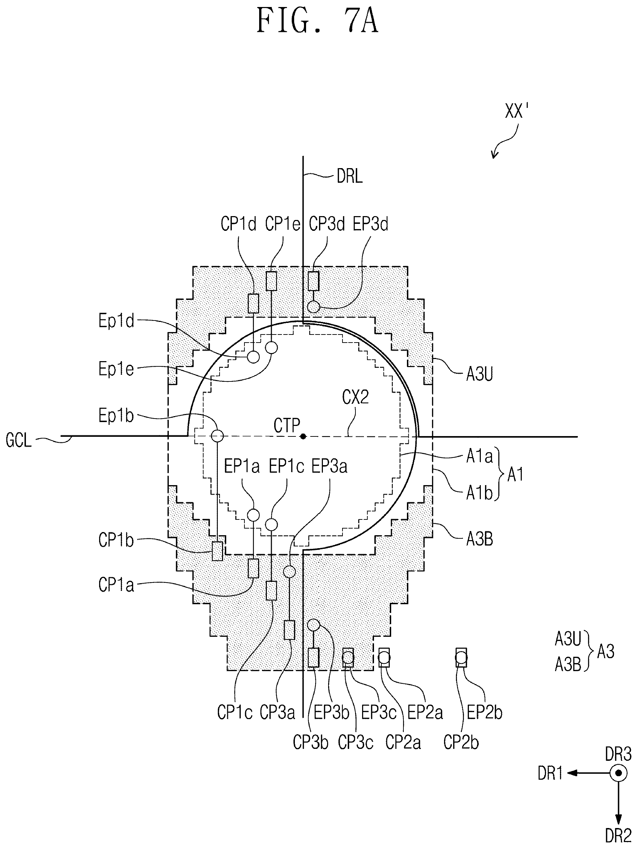

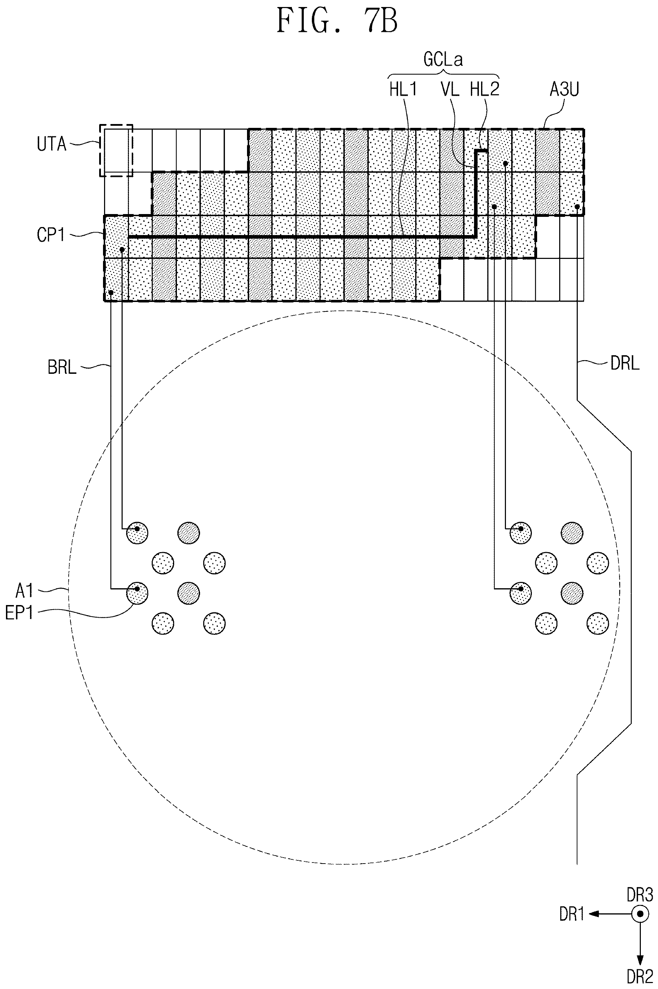

FIG. 7A is a plan view illustrating a portion of a display panel. FIG. 7B is a schematic view illustrating a portion of a display panel. FIG. 7A illustrates an enlarged view of area XX' illustrated in FIG. 4, and illustrates an area corresponding to FIG. 6A. FIG. 7B illustrates an area corresponding to FIG. 6C. Hereinafter, an example will be described with reference to FIGS. 7A and 7B. The same/similar components as/to those described with reference to FIGS. 1A - 6C are designated by the same/similar reference numbers or symbols, and the redundant contents are omitted.

Referring to FIG. 7A, a third area A3 may include an upper sub-area A3U and a lower sub-area A3B. The upper side may be a position in an opposite direction to the second direction DR2 from the center CTP of a first area A1, and the lower side may be a position in the same direction as the second direction DR2 from the center CTP of the first area A1. The upper sub-area A3U may be disposed on the upper side on the basis of the first area A1, and the lower sub-area A3B may be disposed on the lower side on the basis of the first area A1.

In this example, the upper sub-area A3U and the lower sub-area A3B may be spaced (e.g., spaced apart) from each other with the first area A1 disposed between the upper sub-area A3U and the lower sub-area A3B. The upper sub-area A3U and the lower sub-area A3B may have an asymmetric shape with respect to a virtual second center axis CX2 passing through the center CTP of the first area A1 and extending to be parallel to the second direction DR2 (or extending in the second direction). In this example, the second center axis CX2 may be a line matching a gate line GCL illustrated herein. Specifically, the upper sub-area A3U and the lower sub-area A3B may have different surface areas. The upper sub-area A3U and the lower sub-area A3B may have different shapes.

As an example, FIG. 7B illustrates only an upper area of the third area A3. The upper sub-area A3U may be an area of the third area A3, in which first pixel drivers CP1 disposed on the upper side with respect to the second center axis CX2 and connected to first emission parts EP1, respectively, are disposed. Likewise, the lower sub-area A3B may be an area of the third area A3, in which the first pixel drivers CP1 disposed on the lower side with respect to the second center axis CX2 and connected to the first emission parts EP1, respectively, are disposed.

The upper sub-area A3U may have an irregular shape. An arrangement of the first pixel drivers CP1 disposed in the upper sub-area A3U may be left-right asymmetric. As illustrated in FIG. 7B, the first pixel drivers CP1 corresponding to the first emission parts EP1 arranged on the same row in the first area A1 may not be arranged on the same row in the third area A3. Two first pixel drivers CP1 respectively connected to the emission parts constituting the same row may be connected to the same gate line GCLa, and thus the gate line GCLa may include at least one vertical portion VL in addition to horizontal portions HL1 and HL2 extending in the first direction DR1. However, the vertical portion VL may be sufficient as long as extending in a direction crossing the horizontal portions HL1 and HL2, and may not mean one orthogonal or perpendicular to the horizontal portions HL1 and HL2.

The vertical portion VL may be provided as one body on the same layer as the horizontal portions HL1 and HL2, or may be disposed on a different layer from the horizontal portions HL1 and HL2 so as to avoid interference with other adjacent signal line and connected to the horizontal portions HL1 and HL2 through a contact hole and/or the like. As the gate line GCLa further includes the vertical portion VL, an arrangement of the pixel drivers CP1 disposed in the third area A3 may be designed independently of the first emission parts EP1, and even when the arrangement of the pixel drivers CP1 is variously changed, the first emission parts EP1 constituting the same row may be easily driven using one gate line GCLa in common. However, this is illustrated as an example, and when the upper sub-area A3U and the lower sub-area A3B have an asymmetric shape, the upper sub-area A3U itself may have a left-right symmetric shape and is not limited.

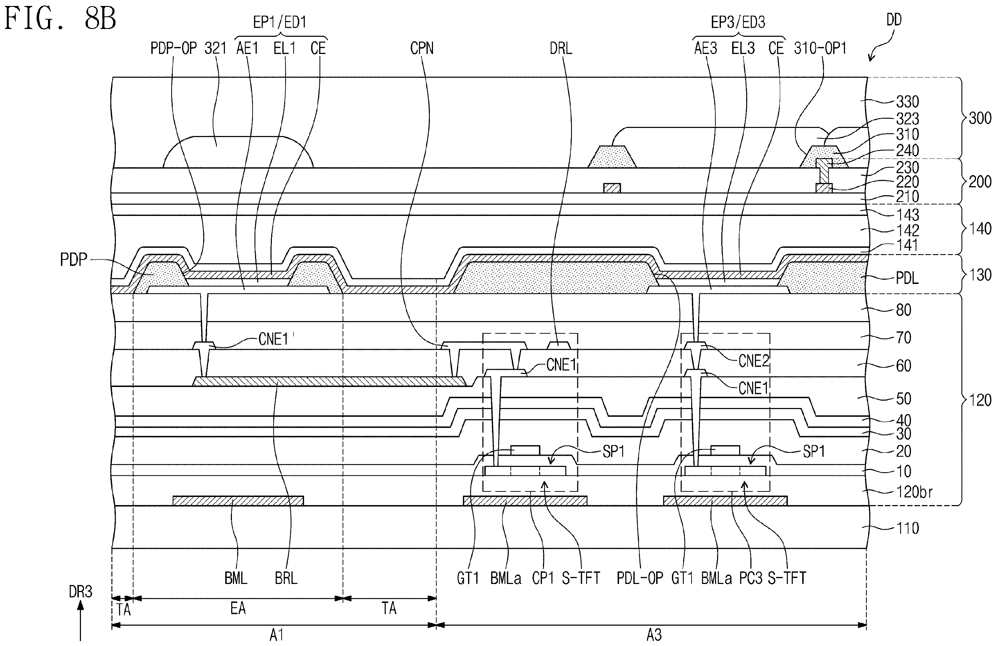

FIGS. 8A and 8B are cross-sectional views of a display device. FIG. 8A is a cross-sectional view of a portion including a second area A2, and FIG. 8B is a cross-sectional view of a portion including a first area A1 and a third area A3.

A display layer 100, a sensor layer 200, and an anti-reflective layer 300, which constitute a display device DD, may be stacked in the third direction DR3. The display layer 100 displays an image at the display area DA. The display layer 100 may be referred to as a display panel. The display layer 100 may include a base layer 110, a circuit layer 120, a light emitting element layer 130, and an encapsulation layer 140. The base layer 110 may provide a base surface on which the circuit layer 120 is disposed. The base layer 110 may be a rigid substrate, or a flexible substrate capable of being bent, folded, rolled, and/or the like. The base layer 110 may be a glass substrate, a metal substrate, a polymer substrate, and/or the like. However, the present disclosure is not limited thereto, and the base layer 110 may be an inorganic layer, an organic layer, or a composite material layer.

The circuit layer 120 may be disposed on the base layer 110. The circuit layer 120 may include a plurality of insulating layers 120br, 10, 20, 30, 40, 50, 60, 70, and 80, a semiconductor pattern, a conductive pattern, a signal line, and/or the like. The semiconductor pattern, the conductive pattern, and the signal line may constitute first to third pixel drivers CP1, CP2, and CP3. The insulating layers, a semiconductor layer, and a conductive layer may be formed on the base layer 110 through a method such as coating and deposition, and then, the insulating layers, the semiconductor layer, and the conductive layer may be selectively patterned by performing a photolithography process multiple times to form the semiconductor pattern, the conductive pattern, and the signal line.

A buffer layer 120br may be disposed on the base layer 110. The buffer layer 120br may prevent a phenomenon in which metal atoms or impurities are spread from the base layer 110 to a first semiconductor pattern SP1. In addition, the buffer layer 120br may adjust a heat supply rate during a crystallization process for forming the first semiconductor pattern SP1 so that the first semiconductor pattern SP1 is uniformly formed.

For easy explanation, FIG. 8A illustrates, as an example, one silicon transistor S-TFT, one oxide transistor O-TFT, and a capacitor Cst from among components of the second pixel driver CP2, and FIG. 8B illustrates, as an example, only respective one transistors from among components of the first pixel driver CP1 and the third pixel driver CP3.

A first rear metal layer BMLa may be disposed below the silicon transistor S-TFT, and a second rear metal layer BMLb may be disposed below the oxide transistor O-TFT. The silicon transistor S-TFT may be the transistor including the semiconductor layer including silicon described above. The oxide transistor O-TFT may be the transistor including the semiconductor layer including oxide described above.

The first and second rear metal layers BMLa and BMLb may overlap the first to third pixel drivers CP1, CP2 and CP3. The first and second rear metal layers BMLa and BMLb may be disposed on the base layer 110.

The first and second rear metal layers BMLa and BMLb may prevent an electric potential due to a polarization phenomenon of the base layer 110 from affecting the first to third pixel drivers CP1, CP2 and CP3. The first and second rear metal layers BMLa and BMLb may prevent external light from reaching the first to third pixel drivers CP1, CP2, and CP3. The first and second rear metal layers BMLa and BMLb may not overlap the first area A1.

The first rear metal layer BMLa may be disposed between the base layer 110 and the buffer layer 120br. An inorganic barrier layer may be further disposed between the first rear metal layer BMLa and the buffer layer 120br. The first rear metal layer BMLa may be connected to an electrode or a line, and may receive a constant voltage or a signal from the electrode and the line. The first rear metal layer BMLa may be a floating electrode having a shape isolated from another electrode or line.

The second rear metal layer BMLb may be disposed between a second insulating layer 20 and a third insulating layer 30. The second rear metal layer BMLb may be disposed on (e.g., at) the same layer as a second electrode CE2 of a storage capacitor Cst. The second rear metal layer BMLb may be connected to a contact electrode BML2-C and receive a constant voltage or signal. The contact electrode BML2-C may be disposed on (e.g., at) the same layer as a gate GT2 of the oxide transistor O-TFT.

Each of the first rear metal layer BMLa and the second rear metal layer BMLb may include a reflective metal. The first rear metal layer BMLa and the second rear metal layer BMLb may include the same material, or may include different materials.

Each of the first rear metal layer BMLa and the second rear metal layer BMLb may include silver (Ag), silver (Ag)-containing alloy, molybdenum (Mo), molybdenum-containing alloy, aluminum (Al), aluminum-containing alloy, aluminum nitride (AIN), tungsten (W), tungsten nitride (WN), copper (Cu), a p+ doped amorphous silicon, and/or the like.

The second rear metal layer BMLb may be omitted. In this case, the first rear metal layer BMLa may extend to be at below the oxide transistor O-TFT, and the first rear metal layer BMLa may block light incident from below the oxide transistor O-TFT.

As shown in FIG. 8B, a rear metal layer BML may be disposed below a first emission part EP1. The rear metal layer BML may be disposed between the base layer 110 and the buffer layer 120br. The rear metal layer BML may include the same material as the first rear metal layer BMLa and the second rear metal layer BMLb. The rear metal layer BML may be disposed on (e.g., at) the same layer as the first rear metal layer BMLa. However, the rear metal layer BML is not limited thereto, and may be disposed on (e.g., at) the same layer as the second rear metal layer BMLb. The rear metal layer BML may protect the first emission part EP1 when defining an opening pattern of a common electrode CE to be described later.

The first semiconductor pattern SP1 may be disposed on the buffer layer 120br. The first semiconductor pattern SP1 may include a silicon semiconductor. For example, the silicon semiconductor may include an amorphous silicon, a polycrystalline silicon, and/or the like. Specifically, the first semiconductor pattern SP1 may include a low-temperature polysilicon.

FIGS. 8A and 8B each illustrate a portion of the first semiconductor pattern SP1 disposed on the buffer layer 120br, but the first semiconductor pattern SP1 is not limited thereto and may be further disposed on other areas. The first semiconductor pattern SP1 may be arranged over pixels PX according to a specific rule.

The first semiconductor pattern SP1 may have different electrical properties according to whether the first semiconductor pattern SP1 is doped or not. The first semiconductor pattern SP1 may include a first region with high conductivity and a second region with low conductivity. The first region may be doped with an n-type dopant or a p-type dopant. A p-type transistor may include a doped region doped with the p-type dopant, and an n-type transistor may include a doped region doped with the n-type dopant. The second region may be a non-doped region, or a region doped at a lower concentration than the first region.

The conductivity of the first region may be greater than the conductivity of the second region, and the first region may substantially serve as an electrode or a signal line. The second region may substantially correspond to an active region (or channel) of a transistor. That is, one portion of the semiconductor pattern may be an active region of the transistor, another portion thereof may be a source or a drain of the transistor, and still another portion thereof may be a connection electrode or a connection signal line.

A source region SE1 (or source), an active region AC1 (or channel), and a drain region DE1 (drain) of the silicon transistor S-TFT may be provided from the first semiconductor pattern SP1. The source region SE1 and the drain region DE1 may extend from the active region AC1 in opposite directions on a cross-section.

A first insulating layer 10 may be disposed on the buffer layer 120br. The first insulating layer 10 may overlap, in common, the plurality of pixels PX and cover the first semiconductor pattern SP1. The first insulating layer 10 may be an inorganic layer.

A gate GT1 of the silicon transistor S-TFT may be disposed on the first insulating layer 10. The gate GT1 may be a portion of a metal pattern.

The second insulating layer 20 may be disposed on the first insulating layer 10 and cover the gate GT1. The second insulating layer 20 may be an inorganic layer. The third insulating layer 30 may be disposed on the second insulating layer 20. The third insulating layer 30 may be an inorganic layer.

A first electrode CE1 of the storage capacitor Cst may be disposed between the first insulating layer 10 and the second insulating layer 20. The second electrode CE2 of the storage capacitor Cst may be disposed between the second insulating layer 20 and the third insulating layer 30.

A second semiconductor pattern SP2 may be disposed on the third insulating layer 30. The second semiconductor pattern SP2 may include an oxide semiconductor. The oxide semiconductor may include a plurality of regions divided according to whether a transparent conductive oxide is reduced or not. A region in which the transparent conductive oxide is reduced (hereinafter referred to as a reduced region), has higher conductivity than a region in which the transparent conductive oxide is not reduced (hereinafter referred to as a non-reduced region).

The reduced region substantially serves as a signal line or a source/drain of a transistor. The non-reduced region substantially corresponds to a semiconductor region (or active region or channel) of the transistor. That is, a partial region of the second semiconductor pattern SP2 may be the semiconductor region of the transistor, another partial region thereof may be a source region/drain region of the transistor, and still another partial region thereof may be a signal transfer region.

A source region SE2, an active region AC2, and a drain region DE2 of the oxide transistor O-TFT may be provided from the second semiconductor pattern SP2. The source region SE2 and the drain region DE2 may extend from the active region AC2 in opposite directions on a cross-section.

A fourth insulating layer 40 may be disposed on the third insulating layer 30. The fourth insulating layer 40 may overlap, in common, the plurality of pixels PX and cover the second semiconductor pattern SP2. The fourth insulating layer 40 may be an inorganic layer.

The gate GT2 of the oxide transistor O-TFT may be disposed on the fourth insulating layer 40. The gate GT2 may be a portion of a metal pattern. The gate GT2 may overlap the active region AC2. A fifth insulating layer 50 may be disposed on the fourth insulating layer 40 and cover the gate GT2. The fifth insulating layer 50 may be an inorganic layer and/or an organic layer, and have a single-layer or multilayer structure.

A first connection electrode CNE1 may be disposed on the fifth insulating layer 50. The first connection electrode CNE1 may be connected to the drain region DE1 of the silicon transistor S-TFT through a contact hole passing through the first to fifth insulating layers 10, 20, 30, 40, and 50.

A sixth insulating layer 60 may be disposed on the fifth insulating layer 50 and may cover the first connection electrode CNE1. A second connection electrode CNE2 may be disposed on the sixth insulating layer 60. The second connection electrode CNE2 may be connected to the first connection electrode CNE1 through a contact hole passing through the sixth insulating layer 60.

A seventh insulating layer 70 may be disposed on the sixth insulating layer 60 and cover the second connection electrode CNE2. An eighth insulating layer 80 may be disposed on the seventh insulating layer 70. Each of the sixth insulating layer 60, the seventh insulating layer 70, and the eighth insulating layer 80 may be an organic layer.

The light emitting element layer 130 may be disposed on the circuit layer 120. The light emitting element layer 130 may include a light emitting element. For example, the light emitting element may include an organic light emitting material, an inorganic light emitting material, an organic-inorganic light emitting material, a quantum dot, a quantum rod, a micro LED, or a nano LED.

Cross-sectional configurations of first to third emission parts EP1, EP2, and EP3 may correspond to light emitting elements, respectively. The first emission part EP1 may include a first pixel electrode AE1, a first emission layer EL1, and the common electrode CE. The second emission part EP2 may include a second pixel electrode AE2, a second emission layer EL2, and the common electrode CE. The third emission part EP3 may include a third pixel electrode AE3, a third emission layer EL3, and the common electrode CE. The common electrode CE may have a shape of one body, and may be provided, in common, to first to third pixels PX1, PX2 and PX3. That is, the common electrode CE may be provided, in common, to the pixels PX.

The first pixel electrode AE1, the second pixel electrode AE2, and the third pixel electrode AE3 may be disposed on the eighth insulating layer 80. Each of the first pixel electrode AE1, the second pixel electrode AE2, and the third pixel electrode AE3 may be (semi-)transmissive electrode or a reflective electrode.

The reflective electrode may include Ag, Mg, Al, Pt, Pd, Au, Ni, Nd, Ir, Cr, and/or a compound thereof, and/or the like. The transparent or semi-transparent electrode may include at least one of an indium tin oxide (ITO), an indium zinc oxide (IZO), an indium gallium zinc oxide (IGZO), a zinc oxide (ZnO) or an indium oxide (In₂O₃), or an aluminum-doped zinc oxide (AZO). As an example, each of the first pixel electrode AE1, the second pixel electrode AE2, and the third pixel electrode AE3 may include ITO/Ag/ITO.

A pixel defining film PDL and a pixel defining pattern PDP may be disposed on the eighth insulating layer 80. The pixel defining film PDL and the pixel defining pattern PDP may include the same material and may be formed through the same process.

Each of the pixel defining film PDL and the pixel defining pattern PDP may have a light absorbing property. For example, each of the pixel defining film PDL and the pixel defining pattern PDP may have a black color.

The pixel defining pattern PDP may be disposed in the first area A1. The pixel defining pattern PDP may cover an edge of the first pixel electrode AE1. The pixel defining pattern PDP may have an annular shape when viewed on a plane (e.g., in a plan view). The state when viewed on a plane may mean a state when viewed in the third direction DR3. An opening portion PDP-OP which exposes a portion of the first pixel electrode AE1 may be defined in the pixel defining pattern PDP.

The pixel defining film PDL may be disposed in each of the second area A2 and the third area A3. The pixel defining film PDL may cover an edge of each of the second pixel electrode AE2 and the third pixel electrode AE3. An opening portion PDL-OP which exposes a portion of each of the second pixel electrode AE2 and the third pixel electrode AE3 may be defined in the pixel defining film PDL.

In the first area A1, an area overlapping a portion, at which the first pixel electrode AE1 and the pixel defining pattern PDP are disposed, may be defined as an element area EA, and a remaining area may be defined as a transmission area TA. The first pixel electrode AE1 may be electrically connected to the first pixel driver CP1 disposed in the third area A3. For example, the first pixel electrode AE1 may be electrically connected to the first pixel driver CP1 through a connection line BRL and a connection bridge CPN. The connection line BRL may be connected to the first pixel electrode AE1 in the first area A1 and extend to the third area A3. The connection line BRL may overlap the transmission area TA. The connection line BRL may include a light transmissive material.

The connection line BRL may be disposed between the fifth insulating layer 50 and the sixth insulating layer 60, but is not particularly limited thereto. The connection bridge CPN may be disposed between the sixth insulating layer 60 and the seventh insulating layer 70. The connection bridge CPN may be connected to the connection line BRL and the first pixel driver CP1.

The first emission layer EL1 may be disposed on the first pixel electrode AE1, the second emission layer EL2 may be disposed on the second pixel electrode AE2, and the third emission layer EL3 may be disposed on the third pixel electrode AE3. Each of the first to third emission layers EL1, EL2 and EL3 may emit light of one color of blue, red, or green colors.

The common electrode CE may be disposed on the pixel defining film PDL, the pixel defining pattern PDP, and the first to third emission layers EL1, EL2 and EL3. The common electrode CE may have a shape of one body, and be disposed on the pixel defining film PDL, the pixel defining pattern PDP, and the first to third emission layers EL1, EL2 and EL3.

The common electrode CE may be a transmissive electrode. The common electrode CE may be a transparent or semi-transparent electrode, and may include a metal thin film having a low work function, which includes Li, Ca, LiF/Ca, LiF/Al, Al, Ag, Mg, and/or a compound thereof. In addition, a transparent conductive oxide (TCO) film such as ITO, IZO, ZnO, or In₂O₃ may be disposed on the metal thin film.

A hole control layer may be disposed between the first to third pixel electrodes AE1, AE2, and AE3 and the first to third emission layers EL1, EL2, and EL3. The hole control layer may include a hole transport layer, and further include a hole injection layer. An electron control layer may be disposed between the first to third emission layers EL1, EL2, and EL3 and the common electrode CE. The electron control layer may include an electron transport layer, and further include an electron injection layer.

The encapsulation layer 140 may be disposed on the light emitting element layer 130. The encapsulation layer 140 may include an inorganic layer 141, an organic layer 142, and an inorganic layer 143 which are stacked in sequence, but layers constituting the encapsulation layer 140 are not limited thereto. The inorganic layers 141 and 143 may protect the light emitting element layer 130 from moisture and/or oxygen, and the organic layer 142 may protect the light emitting element layer 130 from foreign matter such as dust particles, and provide a planarized top surface.

The sensor layer 200 may be disposed on a display layer 100. The sensor layer 200 may detect an external input applied from the outside. The external input may be a user's input. The user's input may include various types of external inputs such as part of the user's body, light, heat, pen, and/or pressure.

The sensor layer 200 may be formed on the display layer 100 through a continuous process. The sensor layer 200 may be disposed on the display layer 100. The sensor layer 200 may be referred to as a sensor, an input sensing layer, or an input sensing panel. The sensor layer 200 may be directly disposed on the display layer 100. For example, a separate adhesive member may not be disposed between the sensor layer 200 and the display layer 100. However, the present disclosure is not limited thereto, and the sensor layer 200 may be coupled to the display layer 100 through an adhesive member. The adhesive member may include a general adhesive or adhesive agent.

The sensor layer 200 may include a base layer 210, a first conductive layer 220, a sensing insulating layer 230, and a second conductive layer 240. The base layer 210 may be directly disposed on the display layer 100. The base layer 210 may be an inorganic layer and/or an organic layer. The base layer 210 may have a single-layer structure, or have a multilayer structure in which layers are stacked along the third direction DR3.

The first conductive layer 220 and the second conductive layer 240 may be disposed on the base layer 210. The sensing insulating layer 230 may be disposed between the first conductive layer 220 and the second conductive layer 240. The sensing insulating layer 230 may include an inorganic layer and/or an organic layer. The first conductive layer 220 and the second conductive layer 240 may constitute a sensor electrode. The sensor electrode may include a sensing electrode and/or a driving electrode. In addition, each sensor electrode may have a mesh shape, and a conductive pattern constituting the first conductive layer 220 or a conductive pattern constituting the second conductive layer 240, illustrated in FIG. 8A, may each be a portion of the mesh shape. Each of the first conductive layer 220 and the second conductive layer 240 may include a transparent electrode. Alternatively, the first conductive layer 220 and the second conductive layer 240 may constitute a sensor electrode together with a third conductive layer disposed on a separate layer. As long as the first conductive layer 220 and the second conductive layer 240 constitutes the sensor electrode and detects an external input, the first conductive layer 220 and the second conductive layer 240 may be designed as various embodiments and are not limited.

A black matrix 310 may have a black color. The black matrix 310 may cover the second conductive layer 240 of the sensor layer 200. The black matrix 310 may prevent external light from being reflected by the second conductive layer 240. The black matrix 310 may overlap the second area A2 and the third area A3, but not overlap the first area A1. As the black matrix 310 is not disposed in the first area A1, the transmittance of the first area A1 may be more improved.

A plurality of opening portions 310-OP1 and 310-OP2 may be defined in the black matrix 310. A first opening portions 310-OP1 may overlap the third pixel electrode AE3, and a second opening portion 310-OP2 may overlap the second pixel electrode AE2.

A first color filter 321 may be disposed in the first area A1, a second color filter 322 may be disposed in the second area A2, and a third color filter 323 may be disposed in the third area A3. The first color filter 321 may overlap the first pixel electrode AE1 and may be disposed on a first light emitting element ED1 or a first emission part EP1. The second color filter 322 may overlap the second pixel electrode AE2 and may be disposed on a second light emitting element ED2 a second emission part EP3. The third color filter 323 may overlap the third pixel electrode AE3 and may be disposed on a third light emitting element ED3 or a third emission part EP3.

The first color filter 321 may not be in contact with the black matrix 310. The second color filter 322 may cover the first opening portion 310-OP1, and the third color filter 323 may cover the second opening portion 310-OP2. Each of the second color filter 322 and the third color filter 323 may be in contact with the black matrix 310. Surface areas of the first and second opening portions 310-OP1 and 310-OP2 of the black matrix 310 may be respectively greater than surface areas of the opening portions PDL-OP of the pixel defining film PDL.

The anti-reflective layer 300 may be disposed on the sensor layer 200. The anti-reflective layer 300 may include the black matrix 310, the first color filter 321, the second color filter 322, the third color filter 323, and a planarization layer 330.

The anti-reflective layer 300 may be directly disposed on the sensor layer 200. The anti-reflective layer 300 may reduce reflectance of external light incident from the outside of the display device DD. The anti-reflective layer 300 may be formed on the sensor layer 300 through a continuous process. The anti-reflective layer 300 may include color filters. In addition, the anti-reflective layer 300 may further include a black matrix adjacent to the color filters.

However, the anti-reflective layer 300 is not limited by the foregoing components, and may include a retarder and a polarizer in order to reduce the reflectance of the external light. The retarder and the polarizer may be provided as one polarizing filter. The anti-reflective layer 300 may further include a protective film disposed above or below the polarizing film.

The sensor layer 200 may be omitted. In this case, the anti-reflective layer 300 may be directly disposed on the display layer 100. Positions between the sensor layer 200 and the anti-reflective layer 300 may be exchanged. For example, the anti-reflective layer 300 may be disposed between the display layer 100 and the sensor layer 200.

The display device DD may further include an optical layer disposed on the anti-reflective layer 300. The optical layer may be formed on the anti-reflective layer 300 through a continuous process.

The optical layer may control a direction of light incident from the display layer 100 and improve front luminance of the display device DD. For example, the optical layer may include an organic insulating layer, in which opening portions are defined to respectively correspond to emission areas of the pixels included in the display layer 100, and a high refractive layer which covers the organic insulating layer and is filled in the opening portions. The high refractive layer may have a high refractive index than the organic insulating layer.

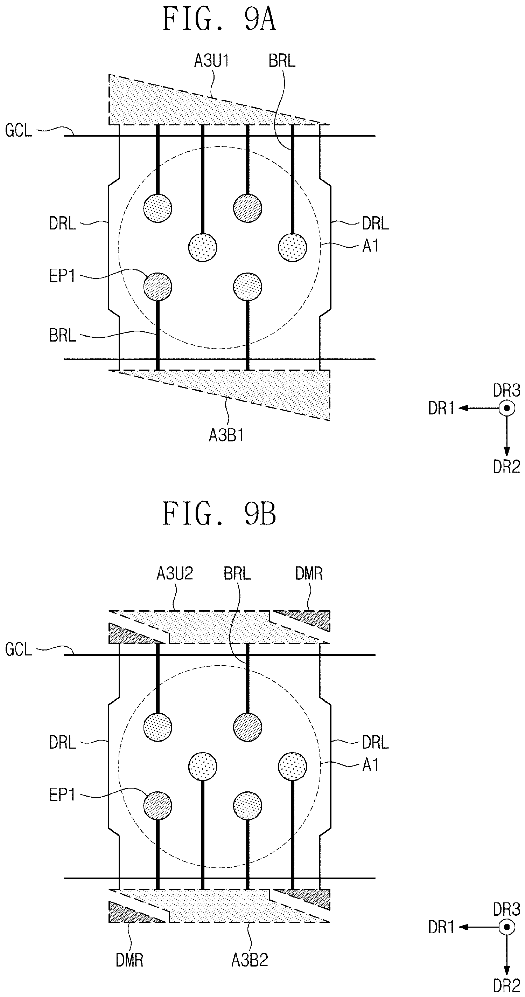

FIGS. 9A - 9D are each a schematic plan view illustrating a partial area of a display panel. In FIGS. 9A - 9D, for easy explanation, respective portions of a first emission part EP1, a connection line BRL, a gate line GCL, and a data line DRL are illustrated, and a third area A3 is shaded. The shaded area may substantially correspond to an area in which first pixel drivers are disclosed, as described above. Hereinafter, an example will be described with reference to FIGS. 9A - 9D. The same/similar components as/to those described with reference to FIGS. 1A - 8B are designated by the same/similar reference numbers or symbols, and the redundant contents are omitted.

Referring to FIG. 9A, an upper sub-area A3U1 and a lower sub-area A3B1 may have an asymmetric shape with respect to a first area A1. The upper sub-area A3U1 may have a right-angled triangle shape having a height on the left, and the lower sub-area A3B1 may have a right-angled triangle shape having a height on the right. That is, the upper sub-area A3U1 and the lower sub-area A3B1 may have a relationship which is not axisymmetric about an axis of symmetry transverse to a center of the first area A1 and parallel to the first direction DR1.

Referring to FIG. 9B, an upper sub-area A3U2 and a lower sub-area A3B2 may have an asymmetric shape with respect to a first area A1. That is, a shape of the upper sub-area A3U2 and a shape of the lower sub-area A3B2 may have a relationship which is not axisymmetric about an axis of symmetry transverse to a center of the first area A1 and parallel to the first direction DR1.

In a display panel, dummy areas DMR may also not be axisymmetric about the axis of symmetry transverse to the center of the first area A1 and parallel to the first direction DR1. A shape of the dummy area DMR disposed on an upper side on the basis of the first area A1 and a shape of the dummy area DMR disposed on a lower side on the basis of the first area A1may have an asymmetric relationship.

The dummy area DMR may be an area in which a first pixel driver CP1 is not disposed. In the dummy area DMR, a circuit (a load matching circuit) such as capacitor, for compensating for resistance may be disposed or a third pixel driver CP3 may be disposed. Alternatively, one of the first to third pixel drivers CP1 to CP3 may not be disposed in the dummy area DMR.

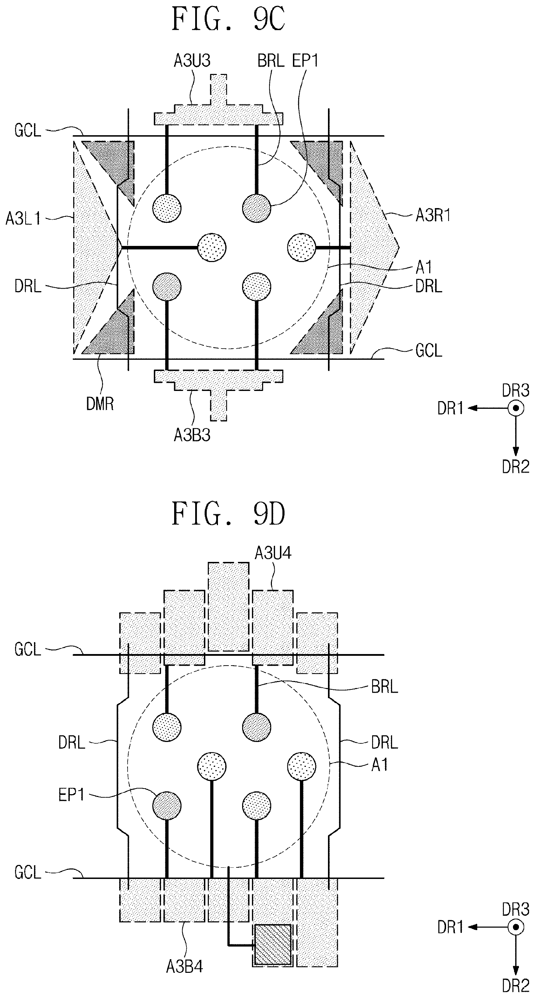

Referring to FIG. 9C, the third area A3 may include an upper sub-area A3U3, a lower sub-area A3B3, a left sub-area A3L1, and a right sub-area A3R1. The third area A3 may include at least two sub-areas having a relationship asymmetric with respect to a first area A1. For example, a shape of the left sub-area A3L1 and a shape of the right sub-area A3R1 may not be axisymmetric with respect to the first area A1. The shape of the left sub-area A3L1 and the shape of the right sub-area A3R1 may have the relationship asymmetric with respect to the first area A1.

The upper sub-area A3U3 and the lower sub-area A3B3 may be axisymmetric with respect to the first area A1. A shape of the upper sub-area A3U3 and a shape of the lower sub-area A3B3 may have a relationship symmetric with respect to the first area A1. However, this is illustrated as an example, and the shapes of the upper sub-area A3U3 and the lower sub-area A3B3 may have a relationship asymmetric with respect to the first area A1, and are not limited.

Referring to FIG. 9D, an upper sub-area A3U4 and a lower sub-area A3B4 may have a shape asymmetric with respect to a first area A1. Five drivers of each of the upper sub-area A3U4 and the lower sub-area A3B4 are illustrated as an example. Here, an arrangement of the five drivers constituting the upper sub-area A3U4 and an arrangement of the five drivers constituting the lower sub-area A3B4 may be different. In addition, surface areas of the five drivers constituting the upper sub-area A3U4 and surface areas of the five drivers constituting the lower sub-area A3B4 may be different from each other. As the respective surface areas or arrangements of the drivers constituting the upper sub-area A3U4 and the lower sub-area A3B4 are set to be different, the upper sub-area A3U4 and the lower sub-area A3B4 may be designed to be asymmetric with respect to the first area A1.

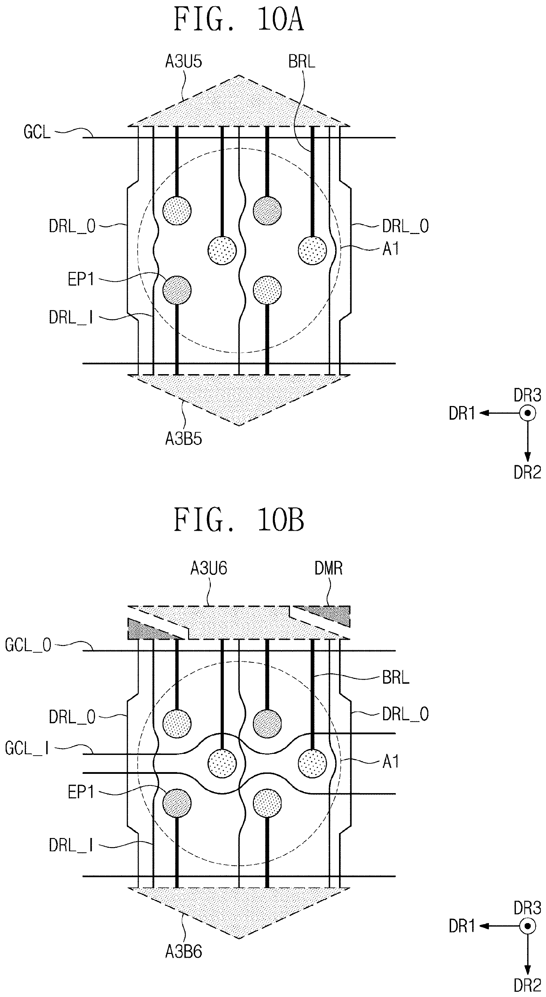

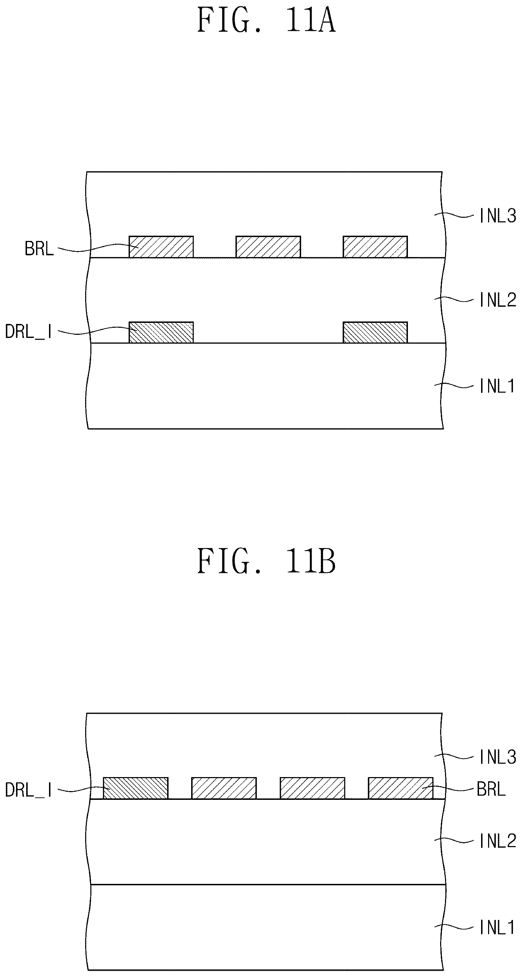

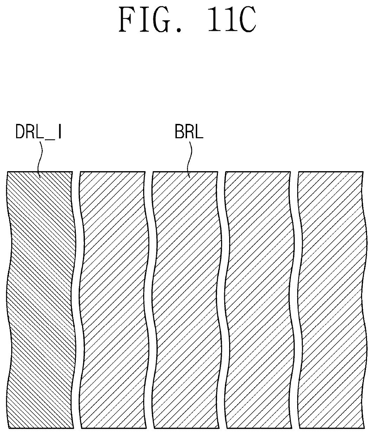

FIGS. 10A and 10B are each a schematic plan view illustrating a partial area of a display panel. FIGS. 11A and 11B are each a cross-sectional view illustrating a portion of a display panel. FIG. 11C is a plan view illustrating a portion of a display panel. FIGS. 10A and 10B illustrate views corresponding to FIG. 9A for easy explanation. FIGS. 11A - 11C illustrate some lines disposed in a first area A1. Hereinafter, an example will be described with reference to FIGS. 10A - 11C. The same/similar components as/to those described with reference to FIGS. 1A - 9D are designated by the same/similar reference numbers or symbols, and the redundant contents are omitted.

Referring to FIGS. 10A and 10B, some of the signal lines may extend across the first area A1.

Referring to FIG. 10A, an upper sub-area A3U5 and a lower sub-area A3B5 may have a shape asymmetric with respect to the first area A1. Here, a display panel DP may include a data line DRL_I passing the first area A1 and a data line DRL_O extending around the first area A1. The data line DRL_I passing the first area A1 may extend along the second direction DR2 and include at least one curve. The data line DRL_I passing the first area A1 may extend while curving.

Referring to FIG. 10B, an upper sub-area A3U6 and a lower sub-area A3B6 may have an asymmetric shape with respect to the first area A1. For easy explanation, the upper sub-area A3U6 and the lower sub-area A3B6 may be illustrated the same as those in FIG. 10A. Here, the display panel DP may further include a gate line GCL_I passing the first area A1. The gate line GCL_I passing the first area A1 may have at least one curve unlike a gate line GCL_O disposed outside the first area A1. The gate line GCL_I passing the first area A1 may be curved and extend along the first direction DR1.

Referring to FIG. 11A, a connection line BRL disposed in the first area A1 and a data line DRL_I passing the first area A1 may be disposed on different layers. That is, the data line DRL_I passing the first area A1 may be disposed between a first insulating layer INL1 and a second insulating layer INL2, and the connection line BRL may be disposed between the second insulating layer INL2 and a third insulating layer INL3. Each of the first to third insulating layers INL1, INL2 and INL3 may include at least one of the insulating layers 120br, 10, 20, 30, 40, 50, 60, 70, or 80 constituting the circuit layer 120 described above.

Referring to FIG. 11A, the connection line BRL disposed in the first area A1 and the data line DRL_I passing the first area A1 may partially overlap each other on a plane. Thus, although FIGS. 10A and 10B illustrate the connection lines BRL and the data lines DRL_I as non-overlapping each other, the connection lines BRL and the data lines DRL_I may be disposed on different layers so that the connection lines BRL and the data lines DRL_I are designed to overlap or intersect each other on a plane to increase diversity of design.

Alternately, as illustrated in FIGS. 11B and 11C, a connection line BRL disposed in the first area A1 and a data line DRL_I passing the first area A1 may be disposed at a same layer. In a case in which the connection line BRL and the data line DRL_I passing the first area A1 extend in the same direction, the connection line BRL and the data line DRL_I passing the first area A1 may be disposed at a same layer, and spaced apart from each other so as not to overlap on a plane. A distance between the connection line BRL and the data line DRL_I passing the first area A1 may be reduced so that both the connection line BRL and the data line DRL_I passing the first area A1 are disposed within the limited first area A1.

The signal lines GCL, GCL_I, GCL_O, DRL, DRL_I and DRL_O may be designed in various shapes as long as not being connected to the connection line BRL, and are not limited.

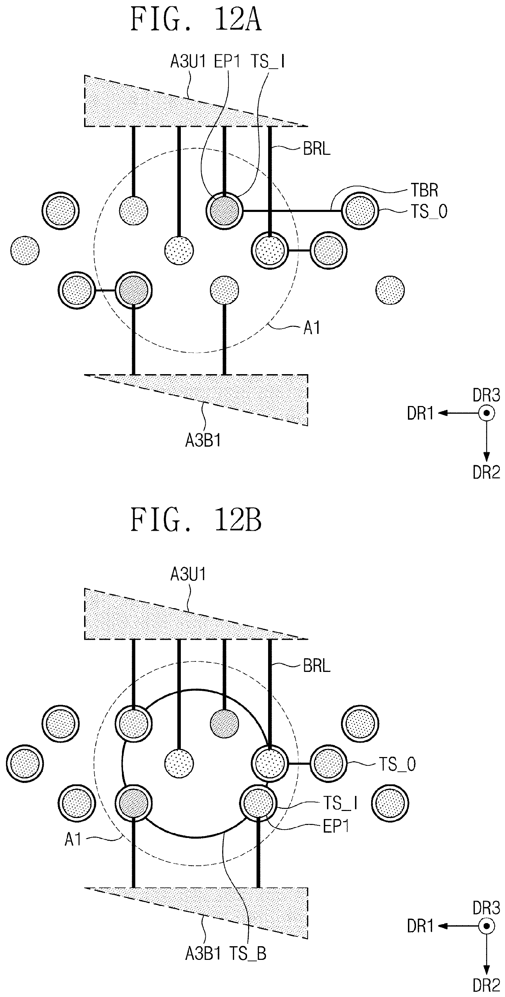

FIGS. 12A and 12B are each a schematic plan view illustrating a partial area of a display panel. For easy explanation, FIGS. 12A and 12B each illustrate an example including an upper sub-area A3U1 and a lower sub-area A3B1 corresponding to those in FIG. 9A. Hereinafter, an example will be described with reference to FIGS. 12A and 12B. Meanwhile, the same/similar components as/to those described with reference to FIGS. 1A to 11C are designated by the same/similar reference numbers or symbols, and the redundant contents are omitted.

Referring to FIG. 12A, at least a portion of a sensor electrode may be disposed in a first area A1. That is, at least a portion of the first conductive layer 220 (see FIG. 8A) or the second conductive layer 240 (see FIG. 8A), each of which constitutes the sensor layer 200 (see FIG. 8A), may be disposed in the first area A1. The sensor electrode may include a conductive pattern TS_O disposed in an area other than the first area A1, and a conductive pattern TS_I disposed in the first area A1. Some of first emission parts EP1 disposed in the first area A1 may each be surrounded by the conductive pattern TS_I disposed in the first area A1 on a plane. The conductive pattern TS_O disposed in the area other than the first area A1, and the conductive pattern TS_I disposed in the first area A1 may be connected to each other through a certain connection line TBR. The connection line TBR may be provided in plurality, and the plurality of the connection lines TBR may respectively connect the plurality of conductive pattern TS_I disposed in the first area A1 to the plurality of conductive patterns TS_O disposed in the area other than the first area A1. Accordingly, sensitivity in the first area A1 may be subdivided and improved.

Referring to FIG. 12B, conductive patterns TS_I disposed in the first area A1 may be connected to each other through a sensor connection line TS_B disposed in the first area A1. The sensor connection line TS_B may be disposed within the first area A1 and connect the plurality of conductive patterns TS_I disposed in the first area A1 to each other. Accordingly, even when only some of the plurality of conductive patterns TS_I disposed in the first area A1 are connected, through the connection line TBR, to the conductive patterns TS_I disposed in the first area A1, an electrical signal may be applied to all the conductive patterns TS_I disposed in the first area A1, thereby easily detecting an external input. Accordingly, the design of the sensor layer 200 in the first area A1 may be simplified.

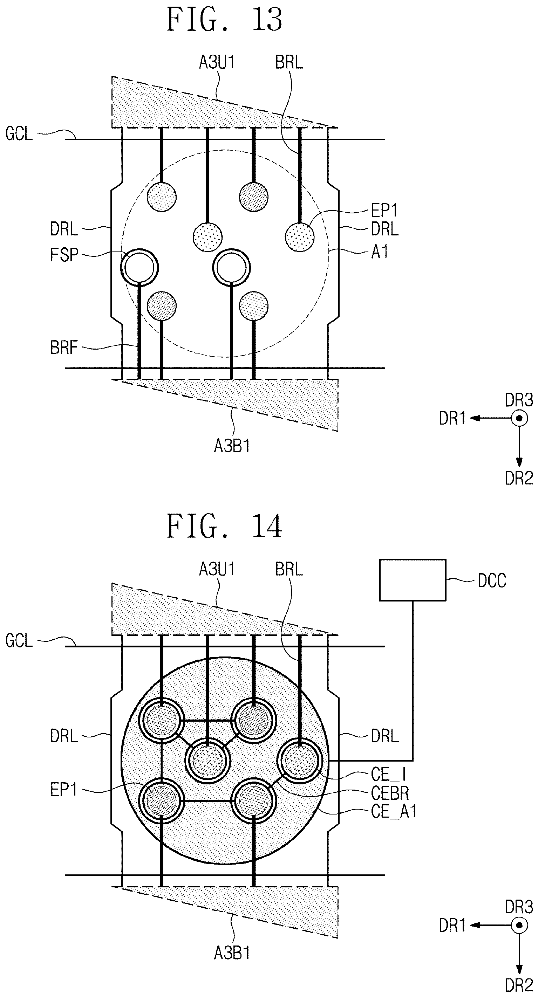

FIG. 13 is a schematic plan view illustrating a partial area of a display panel. FIG. 14 is a schematic plan view illustrating a partial area of a display panel. For easy explanation, FIGS. 13 and 14 each illustrate an area corresponding to FIG. 9A. Hereinafter, an example will be described with reference to FIGS. 13 and 14. The same/similar components as/to those described with reference to FIGS. 1A to 12B are designated by the same/similar reference numbers or symbols, and the redundant contents are omitted.

Referring to FIG. 13, the display panel may further include a fingerprint sensor FSP disposed in a first area A1. The fingerprint sensor FSP may include a light sensing element. The fingerprint sensor FSP may be connected, through a connection line BRF, to a driver disposed in a lower sub-area A3B1. A driver for detecting the fingerprint sensor FSP may be disposed in an area other than the first area A1, thereby preventing a decrease in transmittance of the first area A1. In addition, as the fingerprint sensor FSP is disposed in the first area A1, the first area A1 may be provided as an area on which an image is displayed and through which a fingerprint may be sensed, thereby providing various user environments.

Referring to FIG. 14, the display panel may further include common electrodes CE_A1 and CE_I patterned in a first area A1. The patterned common electrodes CE_A1 and CE_I may include a portion CE_A1 overlapping a transmission part of the first area A1, and a portion CE_I overlapping each of first emission parts EP1. The portion CE_I overlapping the first emission part EP1 may be provided in plurality, and the plurality of portions CE_I may be connected to each other through a connection line CEBR. The portion CE_A1 overlapping the transmission part of the first area A1, and the portions CE_I overlapping the first emission parts EP1 may be electrically separated from or connected to each other. The patterned common electrodes CE_A1 and CE_I may each include an optically transparent conductive material. Accordingly, the transmittance of the first area A1 may be prevented from being decreased.

The patterned common electrodes CE_A1 and CE_I may have an island shape separated from an adjacent second area A2 or third area A3. These patterned common electrodes CE_A1 and CE_I each may be connected to a second emission part or third emission part, which is not illustrated, through a separate connection line or the like.

The patterned common electrodes CE_A1 and CE_I may be connected to a driver DCC. The driver DCC may provide a cathode voltage to the patterned common electrodes CE_A1 and CE_I or connect the patterned common electrodes CE_A1 and CE_I to the sensor layer 200 (see FIG. 8A). That is, according to a mode, the patterned common electrodes CE_A1 and CE_I may function as a cathode for allowing the first emission part EP1 to emit light, or function as a driving electrode or sensing electrode for sensing an external input. , one electrode may be used to drive the emission part EP1 or drive the sensor layer 200, thereby simplifying the design or process for the display panel.

According to embodiments, the areas in which the pixel drivers, which drive the emission parts disposed in the area overlapping the electronic module, are disposed may be designed in the asymmetric shape. Therefore, the electronic apparatus with the improved design degrees of freedom without the constraints on the arrangement of the emission parts may be provided.

In the above, description has been made with reference to embodiments, but those of ordinary skill in the art may understand that various modifications and changes may be made to the present disclosure insofar as such modifications and changes do not depart from the scope of the invention as set out in the claims.

## Claims

1. An electronic apparatus comprising:
an electronic module; and
a display panel including a first area (A1) overlapping the electronic module on a plane,
wherein the display panel comprises:
a plurality of first pixels (PX1) configured to provide light to the first area;
a plurality of second pixels (PX2) configured to provide light to a second area (A2), the second area having a lower light transmittance than the first area; and
a plurality of third pixels (PX3) configured to provide light to a third area (A3), the third area being between the first area (A1) and the second area (A2),
wherein the first pixels comprise:
a plurality of first emission parts (EP1a - e) in the first area;
a first group of first pixel drivers (CP1d, CP1e) at one side of the first area and connected to some of the first emission parts; and
a second group of first pixel drivers (CP1a - CP1c) at an opposite side of the first area in a first direction and connected to others of the first emission parts,
wherein the third area (A3) comprises:
a first sub-area (A3L, A3U) having the first pixel drivers (CP1d, CP1e) of the first group; and
a second sub-area (A3R, A3B) having the first pixel drivers (CP1a - CP1c) of the second group,
wherein the first and second sub-areas are asymmetric about an axis (CX1, CX2) passing through the center (CTP) of the first area in a second direction that is perpendicular to the first direction.

2. The electronic apparatus of claim 1, wherein the first and second sub-areas are symmetric about an axis passing through the center of the first area in the first direction.

3. The electronic apparatus of claim 1, where first and second sub-areas are asymmetric about an axis passing through the center of the first area in the first direction.

4. The electronic apparatus of claim 1, 2 or 3, wherein the first pixel drivers of the first group have an arrangement that is different from the arrangement of the first pixel drivers of the second group.

5. The electronic apparatus of any one of the preceding claims, wherein surface areas of the first pixel drivers of the first group and surface areas of the first pixel drivers of the second group are different from each other.

6. The electronic apparatus of any one of the preceding claims, wherein the number of the first pixel drivers of the first group and the number of the first pixel drivers of the second group are different.

7. The electronic apparatus of any one of the preceding claims, wherein at least one of the first and second sub-areas further comprises a dummy area, the dummy area not being connected to the first emission parts.

8. The electronic apparatus of claim 7, wherein dummy area of the first and second sub-areas is asymmetric with respect to the first area.

9. The electronic apparatus of any one of the preceding claims, wherein at least one of the first pixel drivers of the first group is connected to at least one of the first pixel drivers of the second group through a signal line, and
wherein the signal line extends to overlap the first area.

10. The electronic apparatus of claim 9, wherein the signal line has a curved shape along an extension direction.

11. The electronic apparatus of claim 9, wherein the signal line is on the same layer as a connection line connecting the first pixel drivers and the first emission parts, and wherein the signal line is spaced from the connection line on a plane.

12. The electronic apparatus of claim 9, wherein the signal line is on a different layer from a connection line connecting the first pixel drivers and the first emission parts.

13. The electronic apparatus of any one of the preceding claims, further comprising a sensor layer on the first to third pixels,
wherein the sensor layer comprises a plurality of conductive patterns, and
wherein at least a portion of the conductive patterns overlaps the first area on a plane.

14. The electronic apparatus of any one of the preceding claims, further comprising a light sensing element in the first area.

15. The electronic apparatus of any one of the preceding claims, wherein each of the first to third pixels comprises a pixel electrode, a common electrode on the pixel electrode, and an emission layer located between the pixel electrode and the common electrode, and
wherein the common electrode of the first pixel and the common electrode of the third pixel are spaced from each other on a plane.
